(19) Europäisches Patentamt
European Patent Office
Office européen des brevets

(11) EP 3 648 357 B1

(12) # EUROPEAN PATENT SPECIFICATION

(45) Date of publication and mention of the grant of the patent:
**05.04.2023 Bulletin 2023/14**

(21) Application number: **18822587.4**

(22) Date of filing: **15.05.2018**

(51) International Patent Classification (IPC):
***H03M 13/11*** *(2006.01)* ***H03M 13/03*** *(2006.01)*
***H04L 1/00*** *(2006.01)*

(52) Cooperative Patent Classification (CPC):
**H03M 13/116; H03M 13/036; H03M 13/1185; H03M 13/6306; H03M 13/6393; H03M 13/6516; H04L 1/0041; H04L 1/0043; H04L 1/0057**

(86) International application number:
**PCT/CN2018/086927**

(87) International publication number:
**WO 2019/001159 (03.01.2019 Gazette 2019/01)**

(54) **ENCODING METHOD AND APPARATUS, AND COMPUTER STORAGE MEDIUM**

CODIERUNGSVERFAHREN UND -VORRICHTUNG SOWIE COMPUTERSPEICHERMEDIUM

PROCÉDÉ ET APPAREIL DE CODAGE, ET SUPPORT DE MÉMORISATION INFORMATIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.06.2017 CN 201710496055**

(43) Date of publication of application:
**06.05.2020 Bulletin 2020/19**

(73) Proprietor: **Datang Mobile Communications Equipment Co., Ltd.**
**Beijing 100085 (CN)**

(72) Inventors:
- **WANG, Jiaqing**
  **Beijing 100191 (CN)**
- **MU, Xijin**
  **Beijing 100191 (CN)**
- **ZHANG, Di**
  **Beijing 100191 (CN)**
- **BAI, Baoming**
  **Beijing 100191 (CN)**
- **SUN, Shaohui**
  **Beijing 100191 (CN)**

(74) Representative: **Cabinet Nony**
**11 rue Saint-Georges**
**75009 Paris (FR)**

(56) References cited:
**CN-A- 102 904 583** **US-A1- 2010 257 425**
**US-A1- 2011 289 375**

- **ERICSSON: "LDPC Code Design for NR", 3GPP DRAFT; R1-1608875_LDPC CODE DESIGN FOR NR, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE , vol. RAN WG1, no. Lisbon, Portugal; 20161010 - 20161014 1 October 2016 (2016-10-01), XP051159202, Retrieved from the Internet: URL:http://www.3gpp.org/ftp/tsg_ran/WG1_RL1/TSGR1_86b/Docs/ [retrieved on 2016-10-01]**
- **CATT: "LDPC design for eMBB data", 3GPP DRAFT; R1-1710046, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE , vol. RAN WG1, no. Qingdao, P.R. China; 20170627 - 20170630 19 June 2017 (2017-06-19), XP051305680, Retrieved from the Internet: URL:http://www.3gpp.org/ftp/tsg_ran/WG1_RL1/TSGR1_AH/NR_AH_1706/Docs/ [retrieved on 2017-06-19]**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 648 357 B1

- CATT: "LDPC Design for eMBB data channel", 3GPP DRAFT; R1-1704590 LDPC DESIGN FOR EMBB DATA CHANNEL_FINAL, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE , vol. RAN WG1, no. Spokane, USA; 20170403 - 20170407 2 April 2017 (2017-04-02), XP051242729, Retrieved from the Internet: URL:http://www.3gpp.org/ftp/Meetings_3GPP_SYNC/RAN1/Docs/ [retrieved on 2017-04-02]
- "3rd Generation Partnership Project; Technical Specification Group Radio Access Network; NR; Multiplexing and channel coding (Release 15)", 3GPP STANDARD ; TECHNICAL SPECIFICATION ; 3GPP TS 38.212, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE, vol. RAN WG1, no. V0.0.1, 12 August 2017 (2017-08-12), pages 1-23, XP051336737, [retrieved on 2017-08-12]
- CATT: "LDPC Design for eMBB data channel", 3GPP TSG-RAN WG1 meeting #88 bis, no. R1-1704590, 25 March 2017 (2017-03-25) , XP051251360,
- ZTE: "NR LDPC design", 3GPP TSG-RAN WG1 meeting #89, no. R1-1709534, 19 May 2017 (2017-05-19), XP051285403,

## Description

### Field

The present application relates to the field of LDPC encoding, and particularly to an encoding method and apparatus, and a computer storage medium.

### Background

At present, the Third Generation Partnership Project (3GPP) proposes that there is a need to give a Low Density Parity Check Code (LDPC) channel encoding design for a Enhanced Mobile Broadband (eMBB) scenario in the 5G.

The LDPC is a kind of linear code defined by a check matrix. In order for the decoding feasibility, when a code length is relatively long, the check matrix needs to satisfy the sparsity, that is, the density of "1" in the check matrix is relatively low, namely, the number of "1" in the check matrix is required to be much less than the number of "0", and the longer the code length is, the lower the density is.

However, there is no LDPC encoding solution suitable for the 5G system in the related art.

Document, R1-1608875, titled "LDPC Code Design for NR", presents a set of quasi-cyclic LDPC codes designed for NR, which cover the full range of information block sizes and code rates needed for NR except block lengths of only a few bits where repetition is more suitable. The proposed LDPC codes are designed for a high rate and expanded to achieve lower rate codes, which makes them very suitable for IR HARQ transmission schemes.

Document, US2010/0257425 A1, discloses construction of base matrices for quasi-cyclic (QC)-low density parity-check codes (LDPC) using two novel metrics are described. Design constraints based on a local girth and a local minimum approximate cycle extrinsic message degree (ACE) of variable nodes in the base matrix are employed. In particular, various local girth and local minimum ACE constraints can be set for different lift sizes. Additionally, the base matrix can be configured as a universal base matrix from which different base matrices having different corresponding lift sizes that comply with the design constraints can be obtained and used to generate QC-LDPC codes.

Document, R1-1710046, titled "LDPC design for eMBB data", discusses shifting coefficients design for eMBB LDPC base graphs.

Document, R1-1704590, titled "LDPC design for eMBB data channel", discusses the performance of LDPC codes.

Document, US 2011/0289375 A1, discloses a method for constructing a low-density parity-check (LDPC) code for use in next-generation mobile communication and deep-space communication by using a cyclic distribution; a transmitter; a receiver; and a system. The method includes a block cycle determination step in which the distribution of a block cycle constructed from non-zero cyclic shift element values is determined for the basic matrix of the LDPC code, a priority determination step in which the priorities of the non-zero cyclic shift element values included in each block cycle are determined on the basis of the determined block cycle distribution, and a calculation step in which the greatest common divisor is determined for the permutation elements of all magnitudes in the check matrix of the LDPC code, and the divisor is factored. According to this method, short cycles will not be included in any actual check matrix of an LDPC code constructed by using all different permutation elements.

### Summary

The embodiments of the present application provide an encoding method and apparatus, and a computer storage medium, so as to increase LDPC encoding performance and thus be suitable for the 5G system. The scope of the invention is defined by the appended claims.

### Brief Description of the Drawings

In order to illustrate the technical solutions in the embodiments of the present application more clearly, the accompanying figures that need to be used in describing the embodiments will be introduced below briefly. Obviously the accompanying figures described below are only some embodiments of the present application, and other accompanying figures can also be obtained by those ordinary skilled in the art according to these accompanying figures without creative labor.

Fig. 1 is a structural schematic diagram of a base matrix provided by an embodiment of the present application.

Fig. 2 is a structural schematic diagram of a matrix P provided by an embodiment of the present application.

Fig. 3 is a structural schematic diagram of a circular permutation matrix when z=8 provided by an embodiment of the present application.

Fig. 4 is a structural schematic diagram of a base graph and a cyclic coefficient matrix (z=8) provided by an embodiment of the present application.

Fig. 5 is a structural schematic diagram of an LDPC check matrix supporting the incremental redundancy provided by an embodiment of the present application.

Fig. 6 is a schematic diagram of a set of cyclic matrix sizes Z required to be supported by the 5G LDPC provided by an embodiment of the present application.

Fig. 7 is a structural schematic diagram of a base matrix #2 provided by an embodiment of the present application.

Fig. 8 is a structural schematic diagram of a first cyclic coefficient exponent matrix provided by an embodiment of the present application.

Fig. 9 is a structural schematic diagram of a second cyclic coefficient exponent matrix provided by an embodiment of the present application.

Fig. 10 is a structural schematic diagram of a third cyclic coefficient exponent matrix provided by an embodiment of the present application.

Fig. 11 is a structural schematic diagram of a fourth cyclic coefficient exponent matrix provided by an embodiment of the present application.

Fig. 12 is a structural schematic diagram of a fifth cyclic coefficient exponent matrix provided by an embodiment of the present application.

Fig. 13 is a structural schematic diagram of a sixth cyclic coefficient exponent matrix provided by an embodiment of the present application.

Fig. 14 is a schematic diagram of the girth distribution of the check matrix corresponding to the PCM2 (a=3) R=1/5 employed when Z=128 provided by an embodiment of the present application.

Fig. 15 is a schematic diagram of LDPC cyclic coefficient performance provided by an embodiment of the present application.

Fig. 16 is a flow schematic diagram of an encoding method provided by an embodiment of the present application.

Fig. 17 is a structural schematic diagram of an encoding apparatus provided by an embodiment of the present application.

Fig. 18 is a structural schematic diagram of another encoding apparatus provided by an example of the present application.

**Detailed Description of the Embodiments**

The embodiments of the present application provide an encoding method and apparatus, and a computer storage medium, so as to increase the LDPC encoding performance and thus be suitable for the 5G system.

The technical solution provided by the embodiments of the present application gives the LDPC encoding employed for the data channel in the eMMB scenario instead of the turbo encoding employed by the original Long Term Evolution (LTE) system, i.e., gives the LDPC encoding solution suitable for the 5G system.

The 5G LDPC code design requires a quasi-cyclic LDPC code, and a check matrix H thereof may be represented as:

$$\boldsymbol{H}=\begin{bmatrix} \boldsymbol{A}_{0,0} & \boldsymbol{A}_{0,1} & \cdots & \boldsymbol{A}_{0,c-1} \\ \boldsymbol{A}_{1,0} & \boldsymbol{A}_{1,1} & \cdots & \boldsymbol{A}_{1,c-1} \\ \vdots & \vdots & \ddots & \vdots \\ \boldsymbol{A}_{\rho-1,0} & \boldsymbol{A}_{\rho-1,1} & \cdots & \boldsymbol{A}_{\rho-1,c-1} \end{bmatrix}$$

where $A_{i,j}$ is a circular permutation matrix of z×z.

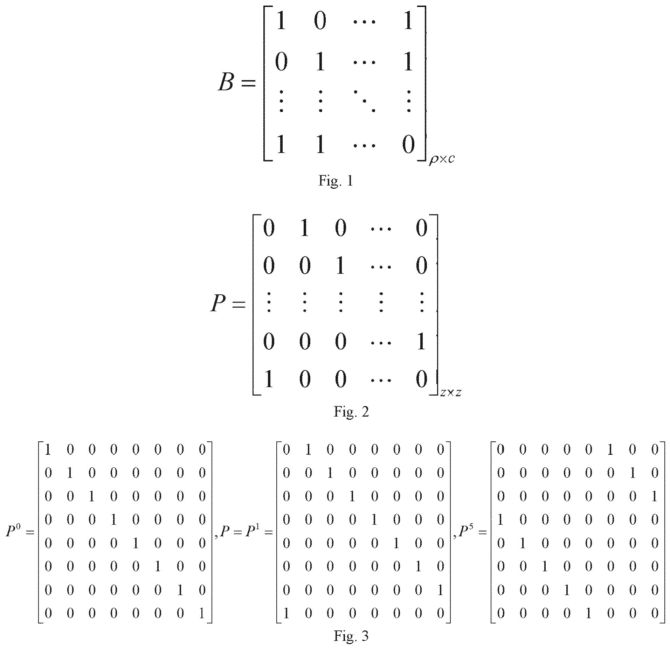

There are several methods of constructing the quasi-cyclic LDPC code. For example, a base matrix of ρ×c is constructed at first, where elements of the base matrix are 0 or 1, as shown in Fig.1. Then each element "1" of the base matrix B is extended as a Circular Permutation Matrix (CPM) of z×z, and the element "0" of the base matrix is extended as an all-zero matrix of z×z. The base matrix B is referred to as a Base Graph (BG) in the subsequent LDPC construction method based on the protograph. Each circular permutation matrix of z×z is represented by $P^i$, where the matrix P is a matrix obtained after a unit matrix cyclically shifts to the right by one digit, as shown in Fig.2, and i is a cyclic shifting label, i.e., a shifting coefficient of a submatrix. Fig.3 gives an instance of a circular permutation matrix $P^i$ (the size of a subgroup is 8×8, i.e., z=8).

Thus, each circular permutation matrix $P^i$ is actually obtained after a unit matrix I cyclically shifts to the right i times, and a cyclic shifting label i of the circular permutation matrix meets $0 \leq i < z, i \in \mathbb{Z}$ .

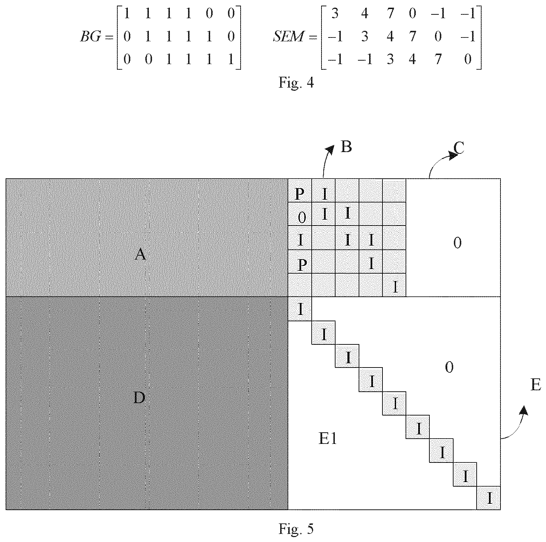

The above-mentioned cyclic shifting label i is also referred to as a cyclic shifting coefficient of an LDPC check matrix. Actually, the cyclic shifting coefficient is an index of a column in which the first row of "1" of a sub-cyclic matrix is located (the label starts from 0, and index = the number of columns -1). Each "1" in a base graph is replaced by a cyclic shifting coefficient of a corresponding sub-cyclic matrix, and each "0" in the base graph is replaced by "-1". Since each cyclic shifting label i is presented in form of matrix exponent, the resulting coefficient matrix is also referred to as the Shifting coefficients Exponent Matrix (SEM). Fig. 4 represents an example of a cyclic coefficient exponent matrix. Here, the BG is a base graph with 3 rows and 6 columns, and each element in the base graph corresponds to a sub-cyclic matrix with 8 rows and 8 columns. The base graph is replaced by the cyclic shifting coefficients of each sub-cyclic matrix, where 0 is replaced by -1, to obtain the cyclic coefficient exponent matrix.

For the sub-cyclic matrix (CM) corresponding to the quasi-cyclic LDPC code described above, the column weight can be greater than 1, for example, the column weight is 2 or the greater value, and at this time, the sub-cyclic matrix is not a circular permutation matrix (CPM) any more.

The 5G LDPC code design requires that IR (Incremental Redundancy)-HARQ (Hybrid Automatic Repeat Request) must be supported, so the LDPC code for the 5G scenario may be constructed by an incremental redundancy method. That is, firstly an LDPC code with high code rate is constructed, and then more check bits produced in the incremental redundancy method to thereby obtain the LDPC code with low code rate. The LDPC code constructed based on the incremental redundancy method has the advantages of fine performance, long code, wide code rate coverage, high reusability, easy hardware implementation, performing the encoding directly using the check matrix, and so on. An instance of the specific structure is as shown in Fig. 5. Here, B is a double diagonal or quasi-double diagonal matrix, C is a 0 matrix, and E is a lower triangular expansion matrix. The design of the LDPC check matrix mainly depends on the designs of A, D and E1.

The LDPC performance depends on two most important factors, where one is the design of the base matrix and the other is how to extend each non-zero element in the base matrix as a circular permutation matrix of $z \times z$. These two factors have the decisive effect on the LDPC performance, and the improper designs of the base matrix and the extended sub-cyclic permutation matrix may deteriorate the performance of the LDPC code greatly.

To sum up, the LDPC check matrix is designed in the 5G design, and the 5G requires the support of the flexible LDPC. By taking the eMBB data channel as an example, the 3GPP requires that at most two LDPC check matrices obtained by extending two base graphs support at most 8/9 code rate and at least 115 code rate, and the information bits are at most 8448 bits and at least 40 bits; for the two base graphs, the larger base graph has 46x68 columns, where the first 22 columns correspond to the information bits and the lowest code rate is 1/3; and the smaller base graph has 42x52 columns, where the lowest code rate is 1/5. Unlike the larger base graph, the smaller base graph is used for increasing the degree of parallelism of the decoding and reducing the decoding delay. The current conclusion of the 3GPP is as follows: when the information bits meet K>640, the first 10 columns in the base graph correspond to the information bits; when the information bits meet 560 <K<=640, the first 9 columns in the base graph correspond to the information bits; when the information bits meet 192 <K<=560, the first 8 columns in the base graph correspond to the information bits; when the information bits meet 40 <K<=192, the first 6 columns in the base graph correspond to the information bits.

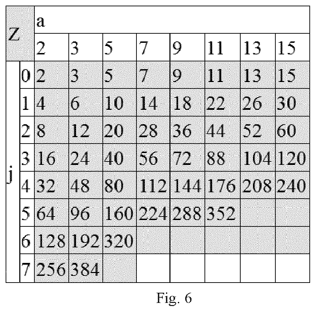

In the 5G LDPC design, in order to enable two fixed base graphs to support the information bit length of 40~8448, the method of extending the sub-cyclic matrix corresponding to each "1" of the base graph as one of the sub-cyclic matrices in different sizes is used, that is, the size Z of the sub-cyclic matrix can support different values. The dimension of the sub-cyclic matrix required to be supported by the 3GPP is $Z = a \times 2^j$, of which the values are specifically as shown in Fig.6. Each Z in the table as shown in Fig.6 corresponds to one check matrix of the LDPC, and as can be seen, the design of the 5G LDPC code needs to design many check matrices. If a cyclic coefficient matrix is designed for each Z, it is uneasy to store and the workload is huge. Thus it is very difficult to find an appropriate method of designing the cyclic coefficients of the LDPC code, which supports a variety of code rates and a variety of information bit lengths and has the low storage complexity. A method is to use the same cyclic coefficient for a plurality of Z, but it is often difficult to obtain the fine performance; and the cyclic coefficient design poses a great challenge to the design of 5G LDPC code.

The detailed introduction of the LDPC encoding method provided by an embodiment of the present application will be given below.

The LDPC encoding method provided by the embodiment of the present application includes following operations.

Operation (1): determining a base graph in combination with actual simulation performance by taking a decoding threshold of a P-EXIT Chart evolved based on the density (a lowest decoding threshold value when the code length is infinite, i.e., a desired lowest SNR value) as a measuring degree.

Operation (2): constructing a cyclic coefficient exponent matrix, where each value of cyclic coefficients represents a cyclic coefficient of one submatrix, and a coefficient i of the $P^i$ described above is at an exponent position, so the matrix here is referred to as the cyclic coefficient exponent matrix, which may also be referred to as an exponent matrix.

The operation (2) includes the first to fourth operations below.

A first operation: dividing the set of dimensions Z of sub-cyclic matrices to be supported into a plurality of subsets.

$Z = a \times 2^j$ ($0 \le j \le 7$, a = {2, 3, 5, 7, 9, 11, 13, 15}), the plurality of subsets is determined in the following way:

a first way: classifying according to a, for example, when a=2, $Z = 2 \times 2^j$ ($0 \le j \le 7$) is a subset, so Z is divided into 8 subsets, where the 8 subsets actually correspond to 8 columns of Fig. 6 respectively, that is, the first subset is the corresponding first column of values in Fig. 6 when a=2, and so on;

a second way: classifying according to j, where for each value of j, $Z = a \times 2^j$ (a = {2, 3, 5, 7, 9, 11, 13, 15}) constitutes a subset; since j has exactly 8 values, j also corresponds to 8 subsets, for example, when j=0, it corresponds to 8 values in the first row in Fig. 6, and so on;

a third way: classifying according to the size of Z, where Kb*Z is the length of information bits, where Kb is the number of the columns of the information bits in the base graph and different from the number K of the information bits; kb=22 for the larger base graph and kb=10 for the smaller base graph, so Z is classified by size, which is equivalent to classifying in accordance with the size of the information bit length K. For example: [2:1:15], [16:2:30], [32:4:64], [72:8:128], [144:16:192], [208:16: 256], [288: 32:320], [352:32:384]. Such classifying method is actually to segment according to the information bit length. The information bit length K is the estimated value of K/kb=Z in unit of bits. When segmented, one example is in accordance with the integer power of 2, where the segments are denser when Z is smaller, and the segments are sparser when Z is larger.

The second way and the third way are not according to the invention and are present for illustration purposes only.

A second operation: generating a cyclic coefficient exponent matrix for each subset, for example by using the method of combining the algebra with the random. Here the random method is for example to produce an exponent matrix randomly, and then pick out the optimum by the subsequent method. The algebra method can be for example to construct a large exponent matrix at first, and then obtain an exponent matrix by using the random masked matrix. Thus 8 subsets totally need 8 cyclic coefficient exponent matrices.

A third operation: further determining the cyclic coefficient corresponding to each Z according to the cyclic coefficient exponent matrix determined in the second operation for each Z in 8 subsets (each subset corresponds to a cyclic coefficient exponent matrix) described above as well as the Z elements outside some sets.

Since the Z elements outside the subsets are considered besides the elements within the subsets in the embodiments of the present application, the coefficient exponent matrix has the better applicability. Firstly since the Z elements within the subsets often have the larger intervals, the 1 bit granularity cannot be achieved. When the Z elements outside the subsets are considered for participating in the cyclic coefficient design, the robustness of the coefficient exponent matrix for the different Z performances may be increased, and another brought benefit is that the same coefficient exponent matrix can be configured for the different subsets, thus further lowering the amount of storage and the hardware design complexity.

Here, each subset produces one exponent matrix, which is actually produced in accordance with the largest Z in the subset, while the coefficient of each specific Z in the subset is a function of the exponent matrix produced by this largest Z. The cyclic coefficients are designed so that the cyclic coefficients of all the Z in the subset have the fine performance and thus the exponent matrix corresponding to this subset is qualified.

The method of determining the cyclic coefficient corresponding to each Z according to the cyclic coefficient exponent matrix is that: the cyclic coefficient $P_{i,j}$ is calculated by using the function of:

$$P_{i,j} = f(V_{i,j}, Z)$$

where $V_{i,j}$ is the cyclic coefficient corresponding to the $(i, j)^{th}$ element in the cyclic coefficient exponent matrix and the function f is defined as:

$$P_{i,j} = \begin{cases} -1 & if\ V_{i,j} == -1 \\ mod(V_{i,j}, Z) & else \end{cases}.$$

A fourth operation: judging the quality of the cyclic coefficient exponent matrix at the set level determined in the second operation for all the Z in each subset, for example, by taking the ring distribution and the minimum distance estimate of the code words as the basic measuring degree, where the larger the ring number and the minimum distance are, the better the performance of the code words is. If the performance of the cyclic coefficient exponent matrix at the set level is bad, the process returns to the second operation.

Here, the ring distribution is the distribution of the ring length, for example, the ring length of the rectangular is 4. The larger one is better. The fact that the ring is never formed means that the graph is not closed, which is called a tree in the graph theory. The minimum distance is the minimum difference between any two code words, where the less difference causes the uneasy distinction, so the code word performance is worse. Thus the performance of the encoded code words is fine only when the minimum distance is large, so that it means that the searched exponent matrix is better, otherwise it means that the exponent matrix should not be used.

Operation (3): extending each cyclic coefficient as the corresponding sub-cyclic matrix according to the cyclic coefficient exponent matrix determined in the operation (2), to finally obtain the check matrix H of the LDPC code.

For example, the matrix H is constituted of the sub-cyclic matrices with 42 rows and 52 columns. Each sub-cyclic matrix is replaced by "0" or "1" to obtain the base graph, and each element "1" of each base graph is replaced by a sub-cyclic matrix to obtain the matrix H. The design of the cyclic coefficient of each submatrix is to select which sub-cyclic matrix to replace "1" in the base graph, and all the cyclic coefficients are placed in one matrix to obtain the cyclic coefficient exponent matrix.

Operation (4): completing the LDPC encoding by using the check matrix H, where each sub-cyclic matrix is obtained directly when the cyclic coefficients and Z are known, to thereby obtain the whole matrix H.

A specific embodiment is given below to illustrate.

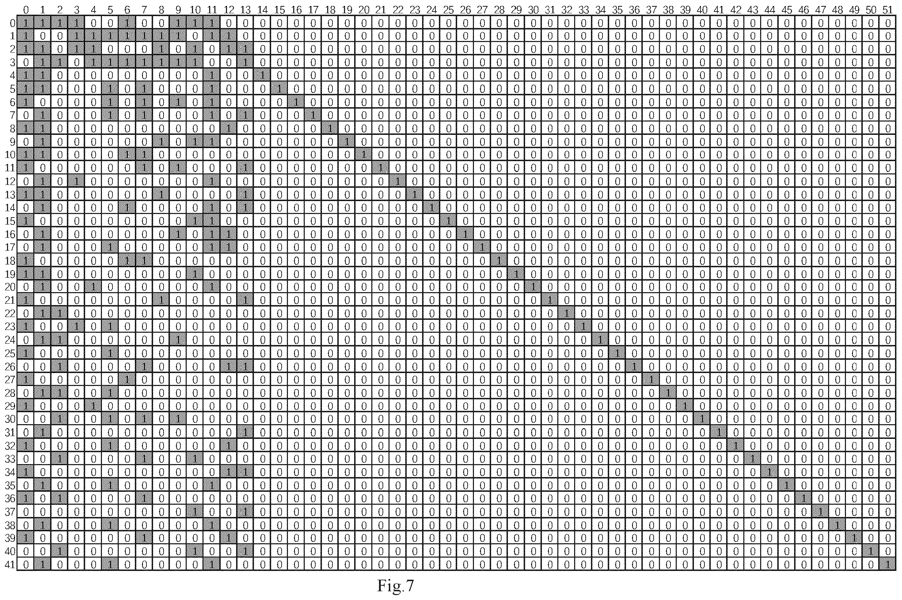

A base graph #2 used by the 5G LDPC design has 42 rows and 52 columns, and the base graph determined currently is as shown in Fig. 7. The 42 rows correspond to the check nodes and the 52 columns correspond to the variable nodes. In the case that the information bits Kb in the above-mentioned base graph is less than 10, for example, Kb=9, the tenth column in the base graph is deleted directly; if kb=6, the seventh to tenth columns of the base graph are deleted and the rows remain unchanged.

According to the base graph as shown in Fig. 7, the set of sizes Z of cyclic matrices as shown in Fig. 6 is classified according to a, i.e., divided according to per column of Fig. 6, a has 8 different values, and accordingly 8 different Z sets are obtained. For example, the Z set corresponding to a=2 is Set1={2, 4, 8, 16, 32, 64, 128, 256}, the Z set corresponding to a=3 is Set2={3, 6, 12, 24, 48, 96, 192, 384}, the Z set corresponding to a=5 is Set3={5, 10, 20, 40, 80, 160, 3201, the Z set corresponding to a=7 is Set4={7, 14, 28, 56, 112, 224}, the Z set corresponding to a=9 is Set5={9, 18, 36, 72, 144, 288}, the Z set corresponding to a=11 is Set6={11, 22, 44, 88, 176, 352}, the Z set corresponding to a=13 is Set7={13, 26, 52, 104, 2081, and the Z set corresponding to a=15 is Set8={15, 30, 60, 120, 240}.

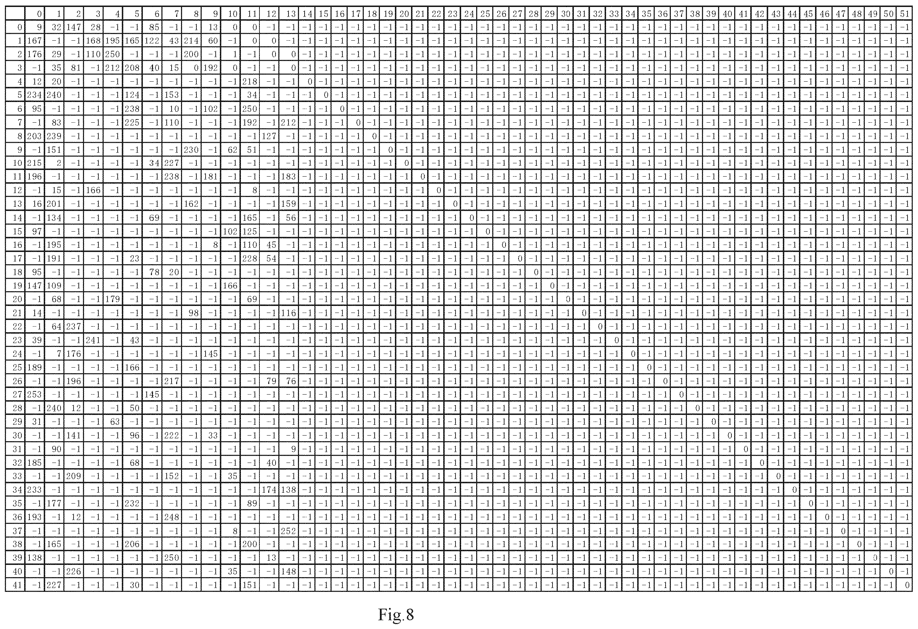

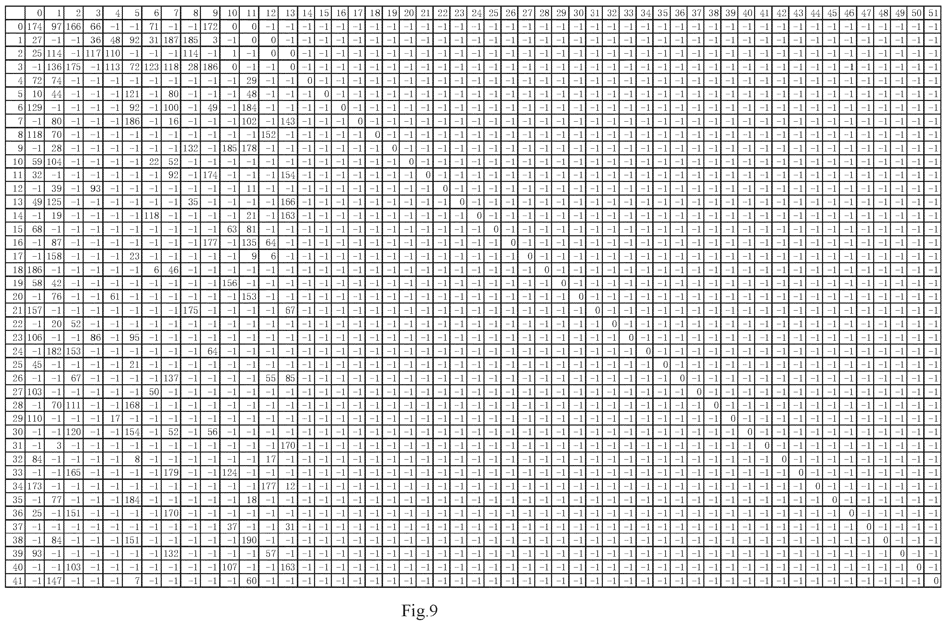

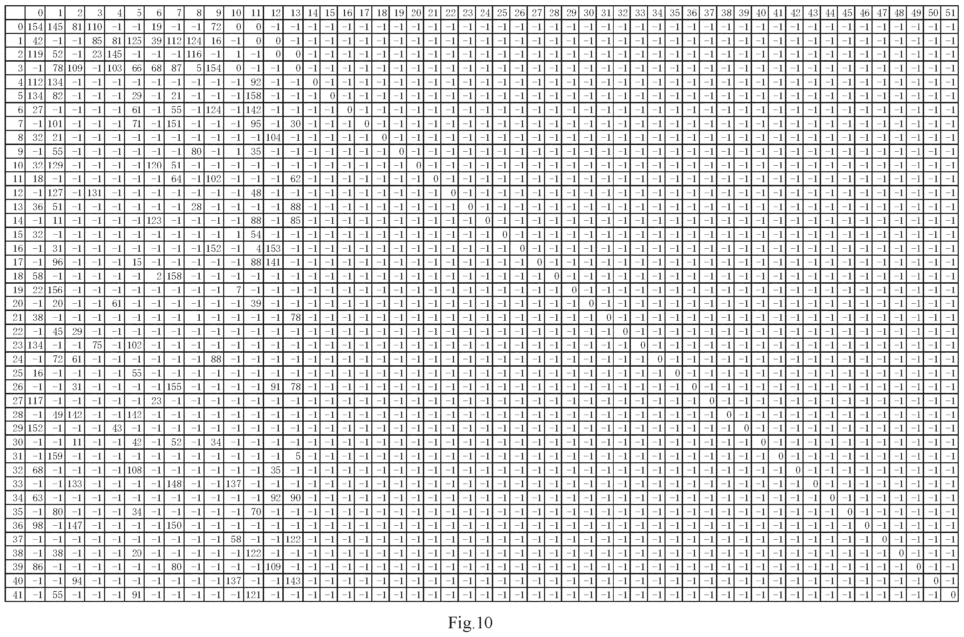

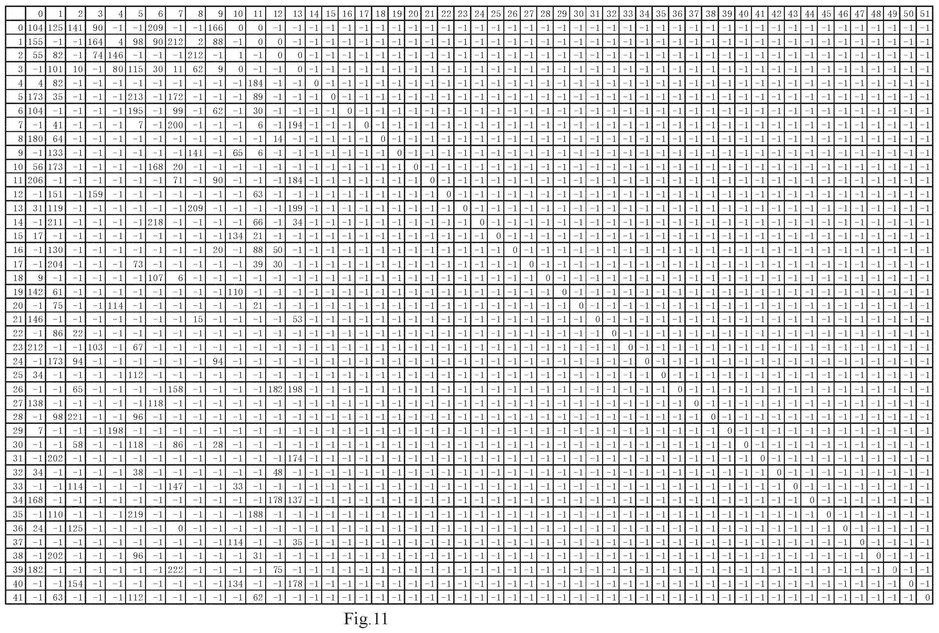

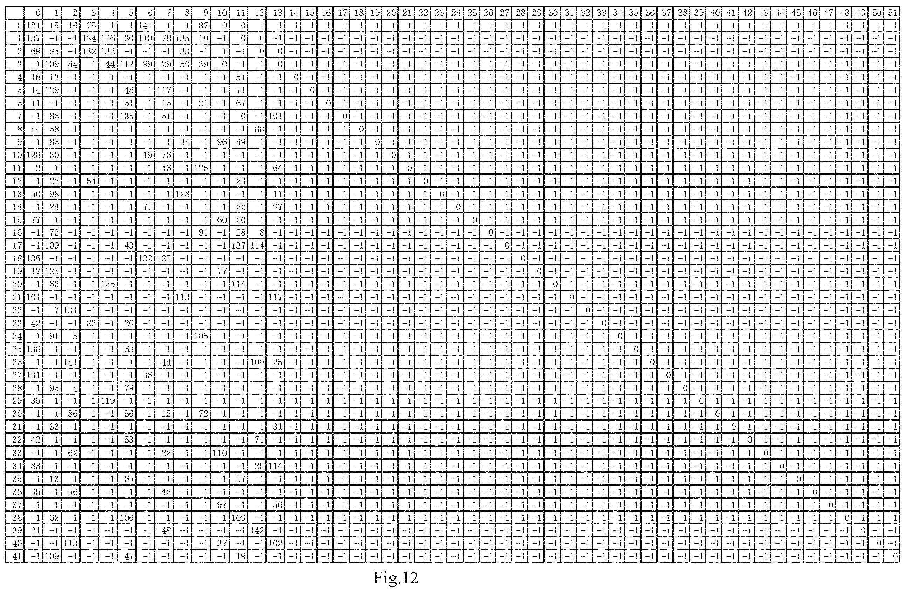

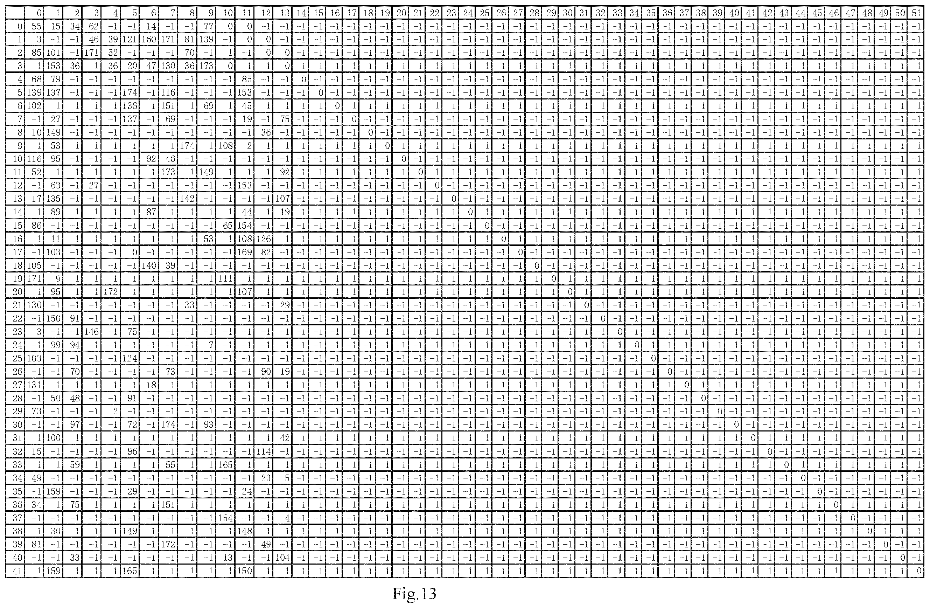

For each Z set, 6 cyclic coefficient exponent matrices PCMi (i=1, 2, 3, ..6) at the set level are determined by the method described in the above operation (2), which are the cyclic coefficient exponent matrices corresponding to the Seti (i=1, 2, 3, ..6) respectively. Here, when a=2, the cyclic coefficient exponent matrix PCM1 corresponding to the Set1 is specifically as shown in Fig. 8; for a=3 according to the invention as defined in the appended claims, the cyclic coefficient exponent matrix PCM2 corresponding to the Set2 is specifically as shown in Fig. 9, where the matrix shown in Fig. 9 is the check matrix in the 5G standard, and the details can refer to the related document; when a=5, the cyclic coefficient exponent matrix PCM3 corresponding to the Set3 is specifically as shown in Fig. 10; when a=7, the cyclic coefficient exponent matrix PCM4 corresponding to the Set4 is specifically as shown in Fig. 11; when a=9, the cyclic coefficient exponent matrix PCM5 corresponding to the Set5 is specifically as shown in Fig. 12; when a=11, the cyclic coefficient exponent matrix PCM6 corresponding to the Set6 is specifically as shown in Fig.13.

As described in the operation (2), when the cyclic coefficient exponent matrix is designed for a set, the matrix is optimized not only according to the coefficients in the set but also according to the coefficients outside the set.

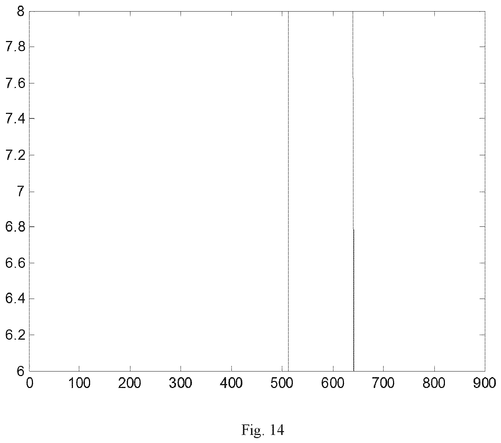

By taking the PCM2 corresponding to the Set2 (a=3) as an example, some Z in the Set1 (a=2) are considered in the design, so that some Z in the Set1 (a=2) also have the fine performance when using the PCM2 matrix of the Set2 (a=3). In an example where Z=128 in the Set1 (a=2), the code rate is 115 and the check matrix corresponding to the PCM2 is used, the girth distribution thereof is as shown in Fig. 14, where the performance is fine due to the sixth and eighth rings.

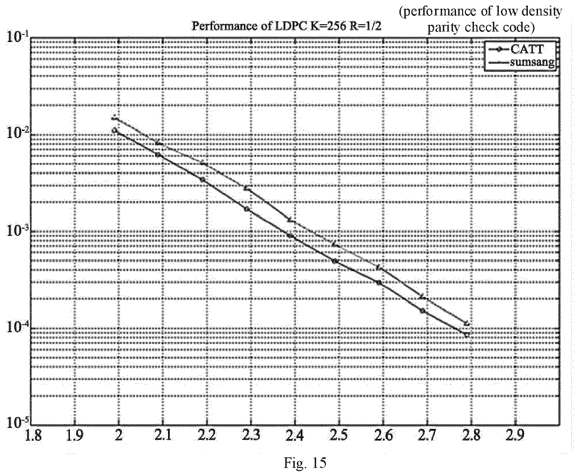

An embodiment of designing the LDPC performance according to the base graph as shown in Figs. 8 to 13 is illustrated in Fig. 15, and as can be seen, the LDPC code performance corresponding to the base graph is better in the embodiment of the present application.

It shall be particularly pointed out that in an embodiment of the present application, the method further includes:

updating the cyclic coefficient exponent matrix; and
updating the sub-cyclic matrix according to the updated cyclic coefficient exponent matrix.

Optionally, the process of updating includes at least the row and column permutations of the matrix elements.

In an embodiment of the present application, the row and column permutations can further be performed on the designed check matrix H, where the row and column permutations include the permutations performed on a part of the elements in the rows and columns besides the usual row and column permutations. By taking the double diagonal matrix shown by the matrix B and the lower triangular structure shown by the matrix E in Fig. 5 as an example, the double diagonal angle and the lower triangular structure may remain unchanged when the permutations are performed, while other elements in the rows and columns are permuted. From the perspective of the coefficient exponent matrix, such permutation can be the exchange among the different rows and columns of the exponent matrix, or can be the exchange of the rows or columns inside a row sub-cyclic matrix represented by a row in the exponent matrix, for example, the first row of the sub-cyclic matrix is permuted as the last row of the sub-cyclic matrix, so the reaction on the numerical value of the exponent matrix is the original coefficient value plus a certain numerical value.

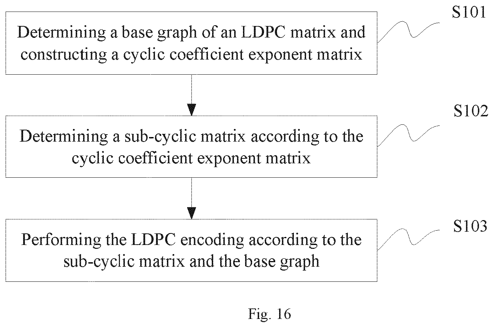

To sum up, referring to Fig. 16, an encoding method provided by an example of the present application includes:

S101: determining a base graph of an LDPC matrix and constructing a cyclic coefficient exponent matrix;
S102: determining a sub-cyclic matrix according to the cyclic coefficient exponent matrix; and
S103: performing LDPC encoding according to the sub-cyclic matrix and the base graph.

The example illustrated in Fig. 16 is not according to the invention and is present for illustration purposes only.

In this method, the base graph of the LDPC matrix is determined and the cyclic coefficient exponent matrix is constructed, the sub-cyclic matrix is determined according to the cyclic coefficient exponent matrix, and the LDPC encoding is performed according to the sub-cyclic matrix and the base graph, so as to increase the LDPC encoding performance and thus be suitable for the 5G system.

The constructing the cyclic coefficient exponent matrix, includes:

a first operation: dividing the set of dimensions Z of the sub-cyclic matrices to be supported into a plurality of subsets;
a second operation: generating a cyclic coefficient exponent matrix for each of the subsets;
a third operation: determining the cyclic coefficient corresponding to Z of the plurality of subsets according to the cyclic coefficient exponent matrix; and
a fourth operation: detecting whether the performance of the determined cyclic coefficient exponent matrix meets the preset condition for each Z, and if so, ending; otherwise reperforming the second operation.

$Z = a\times 2^j$ ($0\leq j\leq 7$, a = {2, 3, 5, 7, 9, 11, 13, 15}); and the first operation is performed in one of the following ways:

a first way: dividing Z into 8 subsets according to the value of a;
a second way: dividing Z into 8 subsets according to the value of j;
a third way: dividing Z into 8 subsets according to the length of information bits.

The second way and the third way are not according to the invention and are present for illustration purposes only.

The third operation includes: determining the cyclic coefficient $P_{i,j}$ corresponding to each Z by the formula of:

$$P_{i,j} = \begin{cases} -1 & if\ V_{i,j} == -1 \\ mod(V_{i,j}, Z) & else \end{cases}$$

where $V_{i,j}$ is the cyclic coefficient corresponding to the (i, j)$^{th}$ element in the cyclic coefficient exponent matrix.

Performing the LDPC encoding according to the sub-cyclic matrix and the base graph, includes:

determining the check matrix according to the sub-cyclic matrix and the base graph; and
performing the LDPC encoding by using the check matrix.

Optionally, after determining the check matrix, the method further includes: performing the row and column permutations for the check matrix; and
performing the LDPC encoding by using the check matrix, includes: performing the LDPC encoding by using the check matrix after the row and column permutations.

Optionally, performing the row and column permutations for the check matrix, includes:
updating a part of row and/or column elements in the check matrix, and/or updating all the row and/or column elements in the check matrix.

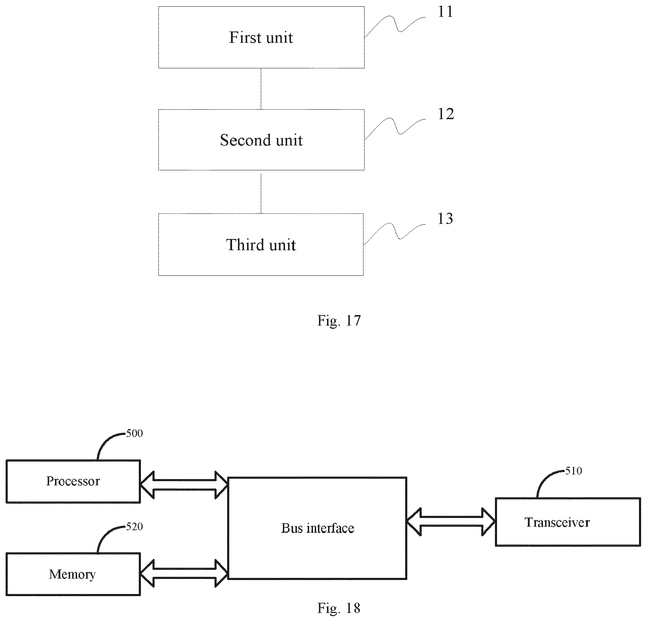

Corresponding to the above-mentioned method, and referring to Fig. 17, an encoding apparatus provided by an example of the present application includes:

a first unit 11 configured to determine a base graph of an LDPC matrix and construct a cyclic coefficient exponent matrix;
a second unit 12 configured to determine a sub-cyclic matrix according to the cyclic coefficient exponent matrix; and

a third unit 13 configured to perform the LDPC encoding according to the sub-cyclic matrix and the base graph. The example illustrated in Fig. 17 is not according to the invention and is present for illustration purposes only.

The first unit constructs the cyclic coefficient exponent matrix, which includes:

a first operation: dividing the set of dimensions Z of the sub-cyclic matrices to be supported into a plurality of subsets;
a second operation: generating a cyclic coefficient exponent matrix for each of the subsets;
a third operation: determining the cyclic coefficient corresponding to Z of the plurality of subsets according to the cyclic coefficient exponent matrix; and
a fourth operation: detecting whether the performance of the determined cyclic coefficient exponent matrix meets the preset condition for each Z, and if so, ending; otherwise reperforming the second operation.

$Z = a \times 2^j$ ($0 \le j \le 7$, a = {2, 3, 5, 7, 9, 11, 13, 15}); and the first unit performs the first operation in one of the following ways:

a first way: dividing Z into 8 subsets according to the value of a;
a second way: dividing Z into 8 subsets according to the value of j;
a third way: dividing Z into 8 subsets according to the length of the information bits.

The third operation includes: determining the cyclic coefficient $P_{i,j}$ corresponding to each Z by the formula of:

$$P_{i,j} = \begin{cases} -1 & if\ V_{i,j} == -1 \\ mod(V_{i,j}, Z) & else \end{cases}$$

where $V_{i,j}$ is the cyclic coefficient corresponding to the (i, j)$^{th}$ element in the cyclic coefficient exponent matrix.
The third unit is configured to:

determine a check matrix according to the sub-cyclic matrix and the base graph; and
perform the LDPC encoding by using the check matrix.

Optionally, the third unit is further configured to perform the row and column permutations for the check matrix after determining the check matrix;
the third unit performs the LDPC encoding by using the check matrix, which includes: performing the LDPC encoding by using the check matrix after the row and column permutations.
Optionally, the third unit performs the row and column permutations for the check matrix, which specifically includes:
updating a part of row and/or column elements in the check matrix, and/or updating all the row and/or column elements in the check matrix.
An example of the present application provides another encoding apparatus, which includes a memory and a processor, where the memory is configured to store the program instructions, and the processor is configured to invoke and obtain the program instructions stored in the memory and perform any one of the above-mentioned methods in accordance with the obtained program instructions.
For example, referring to Fig. 18 which is not according to the invention and is present for illustration purposes only, another encoding apparatus provided by an example of the present application includes a processor 500 configured to read the programs in a memory 520 and perform the processes of:

determining a base graph of a LDPC matrix and constructing a cyclic coefficient exponent matrix;
determining a sub-cyclic matrix according to the cyclic coefficient exponent matrix; and
performing the LDPC encoding according to the sub-cyclic matrix and the base graph.

The processor 500 constructs the cyclic coefficient exponent matrix, which includes:

a first operation: dividing the set of dimensions Z of the sub-cyclic matrices to be supported into a plurality of subsets;
a second operation: generating a cyclic coefficient exponent matrix for each of the subsets;
a third operation: determining the cyclic coefficient corresponding to Z of the plurality of subsets according to the cyclic coefficient exponent matrix; and
a fourth operation: detecting whether the performance of the determined cyclic coefficient exponent matrix meets the preset condition for each Z, and if so, ending; otherwise reperforming the second operation.

$Z = a\times 2^j$ ($0\leq j\leq 7$, a = {2, 3, 5, 7, 9, 11, 13, 15}); and the processor 500 performs the first operation in one of the following ways:

a first way: dividing Z into 8 subsets according to the value of a;
a second way: dividing Z into 8 subsets according to the value of j; and
a third way: dividing Z into 8 subsets according to the length of the information bits.

The third operation includes: determining the cyclic coefficient $P_{i,j}$ corresponding to each Z by the formula of:

$$P_{i,j} = \begin{cases} -1 & if\ V_{i,j} == -1 \\ mod(V_{i,j}, Z) & else \end{cases}$$

where $V_{i,j}$ is the cyclic coefficient corresponding to the (i, j)$^{th}$ element in the cyclic coefficient exponent matrix.

The processor 500 performs the LDPC encoding according to the sub-cyclic matrix and the base graph, which includes:

determining a check matrix according to the sub-cyclic matrix and the base graph;
performing the LDPC encoding by using the check matrix.

Optionally, the processor 500 is further configured to perform the row and column permutations for the check matrix after determining the check matrix; and
the processor 500 performs the LDPC encoding by using the check matrix, which includes: performing the LDPC encoding by using the check matrix after the row and column permutations.

Optionally, the processor 500 performs the row and column permutations for the check matrix, which includes: updating a part of row and/or column elements in the check matrix, and/or updating all the row and/or column elements in the check matrix.

A transceiver 510 is configured to receive and transmit data under the control of the processor 500.

Here, in Fig. 18, the bus architecture can include any numbers of interconnected buses and bridges, and specifically link various circuits of one or more processors represented by the processor 500 and the memory represented by the memory 520. The bus architecture can further link various other circuits such as peripheral device, voltage regulator and power management circuit, which are all well known in the art and thus will not be further described again herein. The bus interface provides an interface. The transceiver 510 can be a plurality of elements, i.e., include a transmitter and a receiver, and provide the units for communicating with various other devices over the transmission media. The processor 500 is responsible for managing the bus architecture and general processing, and the memory 520 can store the data used by the processor 500 when performing the operations.

The processor 500 can be Central Processing Unit (CPU), Application Specific Integrated Circuit (ASIC), Field-Programmable Gate Array (FPGA) or Complex Programmable Logic Device (CPLD).

The encoding apparatus provided by the embodiments of the present application can also be considered as a computing device, which can specifically be a desktop computer, a portable computer, a smart phone, a tablet computer, a Personal Digital Assistant (PDA) or the like. The computing device can include a CPU, a memory, input/output devices and the like. The input device can include a keyboard, a mouse, a touch screen and the like, and the output device can include a display device such as Liquid Crystal Display (LCD), Cathode Ray Tube (CRT) or the like.

The memory can include a Read-Only Memory (ROM) and a Random Access Memory (RAM), and provide the program instructions and data stored in the memory to the processor. In an example of the present application, the memory can be configured to store the program of the encoding method.

The processor invokes and obtains the program instructions stored in the memory and is configured to perform the above-mentioned encoding method in accordance with the obtained program instructions.

A computer storage medium provided by an example of the present application is configured to store the computer program instructions used by the above-mentioned computing device, and the computer program instructions contain the program for performing the above-mentioned encoding method.

The computer storage medium is any available media or data storage device accessible to the computer, including but not limited to magnetic memory (e.g., floppy disk, hard disk, magnetic tape, Magnetic Optical disc (MO) or the like), optical memory (e.g., CD, DVD, BD, HVD or the like), semiconductor memory (e.g., ROM, EPROM, EEPROM, nonvolatile memory (NAND FLASH), Solid State Disk (SSD)) or the like.

It should be understood by those skilled in the art that the embodiments of the present application provide methods, systems and computer program products. Thus the present application takes the form of hardware embodiments alone, software embodiments alone, or embodiments combining the software and hardware aspects. Also the present application takes the form of computer program products implemented on one or more computer usable storage mediums (including but not limited to magnetic disk memories, optical memories and the like) containing computer usable program codes therein.

The present application is described by reference to the flow charts and/or the block diagrams of the methods, the devices (systems) and the computer program products according to the embodiments of the present application. It should be understood that each process and/or block in the flow charts and/or the block diagrams, and a combination of processes and/or blocks in the flow charts and/or the block diagrams can be implemented by the computer program instructions. These computer program instructions can be provided to a general-purpose computer, a dedicated computer, an embedded processor, or a processor of another programmable data processing device to produce a machine, so that an apparatus for implementing the functions specified in one or more processes of the flow charts and/or one or more blocks of the block diagrams is produced by the instructions executed by the computer or the processor of another programmable data processing device.

These computer program instructions can also be stored in a computer readable memory which is capable of guiding the computer or another programmable data processing device to operate in a particular way, so that the instructions stored in the computer readable memory produce a manufacture including the instruction apparatus which implements the functions specified in one or more processes of the flow charts and/or one or more blocks of the block diagrams.

These computer program instructions can also be loaded onto the computer or another programmable data processing device, so that a series of operation steps are performed on the computer or another programmable device to produce the computer-implemented processing. Thus the instructions executed on the computer or another programmable device provide steps for implementing the functions specified in one or more processes of the flow charts and/or one or more blocks of the block diagrams.

Evidently those skilled in the art can make various modifications and variations to the present application without departing from the scope of the present application. Thus the present application is also intended to encompass these modifications and variations therein as long as these modifications and variations to the present application come into the scope of the claims of the present application.

## Claims

**1.** An encoding method, comprising:

determining a base matrix of size 42 rows × 52 columns denoted as base graph BG of a quasi-cyclic Low Density Parity Check Code, LDPC, code, where

each element in the base graph BG is either "0" or "1",
each "0" element in the base graph BG corresponds to an all-zero sub-matrix of size Z×Z in a parity check matrix of the quasi-cyclic LDPC code,
each "1" element in the base graph BG corresponds to a circular permutation matrix, CPM, of size Z×Z in the parity check matrix of the quasi-cyclic LDPC code, and
the CPM corresponding to an "1" element located at position (x, y) in the base graph BG is obtained by circularly shifting a unit matrix of size Z×Z to the right by $P_{x,y}$ times, wherein $P_{x,y} = mod(V_{x,y}, Z)$, and $V_{x,y}$ is a cyclic shift coefficient corresponding to the (x, y)$^{th}$ element in a cyclic coefficient exponent matrix of size 42 × 52 and each "0" element in the base graph BG is represented by "-1" at the corresponding position within the cyclic coefficient exponent matrix;

dividing a set of dimensions Z of CPMs to be supported into a plurality of subsets according to a, wherein $Z=a\times2^j$, including subset Set={3,6,12,24,48,96,192,384} for a=3 and $0\leq j\leq7$;
constructing a cyclic coefficient exponent matrix for the subset Set;
obtaining the parity check matrix of the quasi-cyclic LDPC code by extending each cyclic coefficient as the corresponding CPM according to the constructed cyclic coefficient exponent matrix for the subset Set and the base graph BG; and
performing quasi-cyclic LDPC encoding according to the obtained parity check matrix;
wherein the constructed cyclic coefficient exponent matrix is shown by:

| | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | 30 | 31 | 32 | 33 | 34 | 35 | 36 | 37 | 38 | 39 | 40 | 41 | 42 | 43 | 44 | 45 | 46 | 47 | 48 | 49 | 50 | 51 |
|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|
| 0 | 174 | 97 | 166 | 66 | -1 | -1 | 71 | -1 | -1 | 172 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 1 | 27 | -1 | -1 | 36 | 48 | 92 | 31 | 187 | 185 | 3 | -1 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 2 | 25 | 114 | -1 | 117 | 110 | -1 | -1 | -1 | 114 | -1 | 1 | -1 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 3 | -1 | 136 | 175 | -1 | 113 | 72 | 123 | 118 | 28 | 186 | 0 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 4 | 72 | 74 | -1 | -1 | -1 | -1 | -1 | -1 | -1 | -1 | -1 | 29 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 5 | 10 | 44 | -1 | -1 | -1 | 121 | -1 | 80 | -1 | -1 | -1 | 48 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 6 | 129 | -1 | -1 | -1 | -1 | 92 | -1 | 100 | -1 | 49 | -1 | 184 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 7 | -1 | 80 | -1 | -1 | -1 | 186 | -1 | 16 | -1 | -1 | -1 | 102 | -1 | 143 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 8 | 118 | 70 | -1 | -1 | -1 | -1 | -1 | -1 | -1 | -1 | -1 | -1 | 152 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 9 | -1 | 28 | -1 | -1 | -1 | -1 | -1 | -1 | 132 | -1 | 185 | 178 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 10 | 59 | 104 | -1 | -1 | -1 | -1 | 22 | 52 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 11 | 32 | -1 | -1 | -1 | -1 | -1 | -1 | 92 | -1 | 174 | -1 | -1 | -1 | 154 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 12 | -1 | 39 | -1 | 93 | -1 | -1 | -1 | -1 | -1 | -1 | -1 | 11 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 13 | 49 | 125 | -1 | -1 | -1 | -1 | -1 | -1 | 35 | -1 | -1 | -1 | -1 | 166 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 14 | -1 | 19 | -1 | -1 | -1 | -1 | 118 | -1 | -1 | -1 | -1 | 21 | -1 | 163 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 15 | 68 | -1 | -1 | -1 | -1 | -1 | -1 | -1 | -1 | -1 | 63 | 81 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 16 | -1 | 87 | -1 | -1 | -1 | -1 | -1 | -1 | -1 | 177 | -1 | 135 | 64 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 17 | -1 | 158 | -1 | -1 | -1 | 23 | -1 | -1 | -1 | -1 | -1 | 9 | 6 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 18 | 186 | -1 | -1 | -1 | -1 | -1 | 6 | 46 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 19 | 58 | 42 | -1 | -1 | -1 | -1 | -1 | -1 | -1 | -1 | 156 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 20 | -1 | 76 | -1 | -1 | 61 | -1 | -1 | -1 | -1 | -1 | -1 | 153 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 |
| 21 | 157 | -1 | -1 | -1 | -1 | -1 | -1 | -1 | 175 | -1 | -1 | -1 | -1 | 67 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 |
| 22 | -1 | 20 | 52 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 |
| 23 | 106 | -1 | -1 | 86 | -1 | 95 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 |
| 24 | -1 | 182 | 153 | -1 | -1 | -1 | -1 | -1 | -1 | 64 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 |
| 25 | 45 | -1 | -1 | -1 | -1 | 21 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 |
| 26 | -1 | -1 | 67 | -1 | -1 | -1 | -1 | 137 | -1 | -1 | -1 | -1 | 55 | 85 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 |
| 27 | 103 | -1 | -1 | -1 | -1 | -1 | 50 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 |
| 28 | -1 | 70 | 111 | -1 | -1 | 168 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 |
| 29 | 110 | -1 | -1 | -1 | 17 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 |
| 30 | -1 | -1 | 120 | -1 | -1 | 154 | -1 | 52 | -1 | 56 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 |
| 31 | -1 | 3 | -1 | -1 | -1 | -1 | -1 | -1 | -1 | -1 | -1 | -1 | -1 | 170 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 |
| 32 | 84 | -1 | -1 | -1 | -1 | 8 | -1 | -1 | -1 | -1 | -1 | -1 | 17 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 |
| 33 | -1 | -1 | 165 | -1 | -1 | -1 | -1 | 179 | -1 | -1 | 124 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 |
| 34 | 173 | -1 | -1 | -1 | -1 | -1 | -1 | -1 | -1 | -1 | -1 | -1 | 177 | 12 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 |
| 35 | -1 | 77 | -1 | -1 | -1 | 184 | -1 | -1 | -1 | -1 | -1 | 18 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 |
| 36 | 25 | -1 | 151 | -1 | -1 | -1 | -1 | 170 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 |
| 37 | -1 | -1 | -1 | -1 | -1 | -1 | -1 | -1 | -1 | -1 | 37 | -1 | -1 | 31 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 |
| 38 | -1 | 84 | -1 | -1 | -1 | 151 | -1 | -1 | -1 | -1 | -1 | 190 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 |
| 39 | 93 | -1 | -1 | -1 | -1 | -1 | -1 | 132 | -1 | -1 | -1 | -1 | 57 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 |
| 40 | -1 | -1 | 103 | -1 | -1 | -1 | -1 | -1 | -1 | -1 | 107 | -1 | -1 | 163 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 |
| 41 | -1 | 147 | -1 | -1 | -1 | 7 | -1 | -1 | -1 | -1 | -1 | 60 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 |

.

2. The method according to claim 1, wherein after obtaining the parity check matrix, the method further comprises: performing row and column permutations for the parity check matrix and using the parity check matrix after row and column permutations for performing the quasi-cyclic LDPC encoding.

**3.** The method according to claim 2, wherein the performing row and column permutations for the parity check matrix, further comprises:

performing row and column permutations for a part of row and/or column elements in the parity check matrix; and/or
performing row and column permutations for all the row and/or column elements in the parity check matrix.

**4.** An encoding apparatus, comprising:

a first unit (11), configured to:

determine a base matrix of size 42 rows × 52 columns denoted as base graph BG of a quasi-cyclic Low Density Parity Check Code, LDPC, code, where

each element in the base graph BG is either "0" or "1",
each "0" element in the base graph BG corresponds to an all-zero sub-matrix of size Z×Z in a parity check matrix of the quasi-cyclic LDPC code,
each "1" element in the base graph BG corresponds to a circular permutation matrix, CPM, of size Z×Z in the parity check matrix of the quasi-cyclic LDPC code, and
the CPM corresponding to an "1" element located at position (x, y) in the base graph BG is obtained by circularly shifting a unit matrix of size Z×Z to the right by $P_{x,y}$ times, wherein $P_{x,y} = mod(V_{x,y}, Z)$, and $V_{x,y}$ is a cyclic shift coefficient corresponding to a (x, y)$^{th}$ element in a cyclic coefficient exponent matrix of size 42 × 52 and each "0" element in the base graph BG is represented by "-1" at the corresponding position within the cyclic coefficient exponent matrix;

divide a set of dimensions Z of CPMs to be supported into a plurality of subsets according to a, wherein $Z=a\times 2^j$, including subset Set={3,6,12,24,48,96,192,384} for a=3 and $0\leq j\leq 7$;
construct a cyclic coefficient exponent matrix for the subset Set;
a second unit (12) configured to obtain the parity check matrix of the quasi-cyclic LDPC code by extending each cyclic coefficient as the corresponding CPM according to the constructed cyclic coefficient exponent matrix for the subset Set and the base graph BG; and
a third unit (13) configured to perform quasi-cyclic LDPC encoding according to the obtained parity check matrix;

wherein the constructed cyclic coefficient exponent matrix is shown by:

| | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | 30 | 31 | 32 | 33 | 34 | 35 | 36 | 37 | 38 | 39 | 40 | 41 | 42 | 43 | 44 | 45 | 46 | 47 | 48 | 49 | 50 | 51 |
|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|
| 0 | 174 | 97 | 166 | 66 | -1 | -1 | 71 | -1 | -1 | 172 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 1 | 27 | -1 | -1 | 36 | 48 | 92 | 31 | 187 | 185 | 3 | -1 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 2 | 25 | 114 | -1 | 117 | 110 | -1 | -1 | -1 | 114 | -1 | 1 | -1 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 3 | -1 | 136 | 175 | -1 | 113 | 72 | 123 | 118 | 28 | 186 | 0 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 4 | 72 | 74 | -1 | -1 | -1 | -1 | -1 | -1 | -1 | -1 | -1 | 29 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 5 | 10 | 44 | -1 | -1 | -1 | 121 | -1 | 80 | -1 | -1 | -1 | 48 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 6 | 129 | -1 | -1 | -1 | -1 | 92 | -1 | 100 | -1 | 49 | -1 | 184 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 7 | -1 | 80 | -1 | -1 | -1 | 186 | -1 | 16 | -1 | -1 | -1 | 102 | -1 | 143 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 8 | 118 | 70 | -1 | -1 | -1 | -1 | -1 | -1 | -1 | -1 | -1 | -1 | 152 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 9 | -1 | 28 | -1 | -1 | -1 | -1 | -1 | -1 | 132 | -1 | 185 | 178 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 10 | 59 | 104 | -1 | -1 | -1 | -1 | 22 | 52 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 11 | 32 | -1 | -1 | -1 | -1 | -1 | -1 | 92 | -1 | 174 | -1 | -1 | -1 | 154 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 12 | -1 | 39 | -1 | 93 | -1 | -1 | -1 | -1 | -1 | -1 | -1 | 11 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 13 | 49 | 125 | -1 | -1 | -1 | -1 | -1 | -1 | 35 | -1 | -1 | -1 | -1 | 166 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 14 | -1 | 19 | -1 | -1 | -1 | -1 | 118 | -1 | -1 | -1 | -1 | 21 | -1 | 163 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 15 | 68 | -1 | -1 | -1 | -1 | -1 | -1 | -1 | -1 | -1 | 63 | 81 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 16 | -1 | 87 | -1 | -1 | -1 | -1 | -1 | -1 | -1 | 177 | -1 | 135 | 64 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 17 | -1 | 158 | -1 | -1 | -1 | 23 | -1 | -1 | -1 | -1 | -1 | 9 | 6 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 18 | 186 | -1 | -1 | -1 | -1 | -1 | 6 | 46 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 19 | 58 | 42 | -1 | -1 | -1 | -1 | -1 | -1 | -1 | -1 | 156 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 20 | -1 | 76 | -1 | -1 | 61 | -1 | -1 | -1 | -1 | -1 | -1 | 153 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 |
| 21 | 157 | -1 | -1 | -1 | -1 | -1 | -1 | -1 | 175 | -1 | -1 | -1 | -1 | 67 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 |
| 22 | -1 | 20 | 52 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 |
| 23 | 106 | -1 | -1 | 86 | -1 | 95 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 |
| 24 | -1 | 182 | 153 | -1 | -1 | -1 | -1 | -1 | -1 | 64 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 |
| 25 | 45 | -1 | -1 | -1 | -1 | 21 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 |
| 26 | -1 | -1 | 67 | -1 | -1 | -1 | -1 | 137 | -1 | -1 | -1 | -1 | 55 | 85 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 |
| 27 | 103 | -1 | -1 | -1 | -1 | -1 | 50 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 |
| 28 | -1 | 70 | 111 | -1 | -1 | 168 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 |
| 29 | 110 | -1 | -1 | -1 | 17 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 |
| 30 | -1 | -1 | 120 | -1 | -1 | 154 | -1 | 52 | -1 | 56 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 |
| 31 | -1 | 3 | -1 | -1 | -1 | -1 | -1 | -1 | -1 | -1 | -1 | -1 | -1 | 170 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 |
| 32 | 84 | -1 | -1 | -1 | -1 | 8 | -1 | -1 | -1 | -1 | -1 | -1 | 17 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 |
| 33 | -1 | -1 | 165 | -1 | -1 | -1 | -1 | 179 | -1 | -1 | 124 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 |
| 34 | 173 | -1 | -1 | -1 | -1 | -1 | -1 | -1 | -1 | -1 | -1 | -1 | 177 | 12 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 |
| 35 | -1 | 77 | -1 | -1 | -1 | 184 | -1 | -1 | -1 | -1 | -1 | 18 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 |
| 36 | 25 | -1 | 151 | -1 | -1 | -1 | -1 | 170 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 |
| 37 | -1 | -1 | -1 | -1 | -1 | -1 | -1 | -1 | -1 | -1 | 37 | -1 | -1 | 31 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 |
| 38 | -1 | 84 | -1 | -1 | -1 | 151 | -1 | -1 | -1 | -1 | -1 | 190 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 |
| 39 | 93 | -1 | -1 | -1 | -1 | -1 | -1 | 132 | -1 | -1 | -1 | -1 | 57 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 |
| 40 | -1 | -1 | 103 | -1 | -1 | -1 | -1 | -1 | -1 | -1 | 107 | -1 | -1 | 163 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 |
| 41 | -1 | 147 | -1 | -1 | -1 | 7 | -1 | -1 | -1 | -1 | -1 | 60 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 |

.

**5.** A computer storage medium, storing computer executable instructions that are configured to cause a computer to perform the method of any one of claims 1-3.

## Patentansprüche

**1.** Codierungsverfahren, umfassend:

Bestimmen einer Basismatrix der Größe 42 Zeilen × 52 Spalten, die als Basisgraph BG eines quasi-zyklischen Low Density Parity Check (LDPC)-Codes bezeichnet wird, wobei
jedes Element im Basisgraphen BG entweder "0" oder "l" ist,
jedes Element "0" im Basisgraphen BG einer Null-Untermatrix der Größe Z×Z in einer Kontrollmatrix des quasi-zyklischen LDPC-Codes entspricht,
jedes Element "l" im Basisgraphen BG einer kreisförmigen Permutationsmatrix (Circular Permuation Matrix, CPM) der Größe Z×Z in der Kontrollmatrix des quasi-zyklischen LDPC-Codes entspricht, und
die CPM, die einem Element "l" entspricht, das sich an der Position (x, y) im Basisgraphen BG befindet, durch kreisförmiges Verschieben einer Einheitsmatrix der Größe Z×Z um $P_{x,y}$ Mal nach rechts erhalten wird, wobei $P_{x,y} = mod(V_{x,y}, Z)$ und $V_{x,y}$ ein zyklischer Verschiebungskoeffizient ist, der dem (x, y)-ten Element in einer zyklischen Koeffizienten-Exponentialmatrix der Größe 42 × 52 entspricht, und jedes Element "0" in dem Basisgraphen BG durch "-l" an der entsprechenden Position innerhalb der zyklischen Koeffizienten-Exponentialmatrix dargestellt wird;
Aufteilen eines Satzes von Dimensionen Z von zu unterstützenden CPMs in eine Vielzahl von Untersätzen gemäß a, wobei $Z = a \times 2^j$, einschließlich des Untersatzes Set={3, 6, 12, 24, 48, 96, 192, 384 } für a=3 und $0 \leq j \leq 7$;
Erstellen einer zyklischen Koeffizienten-Exponentialmatrix für den Untersatz Set;
Erhalten der Kontrollmatrix des quasi-zyklischen LDPC-Codes durch Erweitern jedes zyklischen Koeffizienten als die entsprechende CPM gemäß der erstellten zyklischen Koeffizienten-Exponentialmatrix für den Untersatz Set und den Basisgraphen BG; und
Durchführen einer quasi-zyklischen LDPC-Codierung gemäß der erhaltenen Kontrollmatrix;
wobei die erstellte zyklische Koeffizienten-Exponentialmatrix gezeigt wird durch:

| | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | 30 | 31 | 32 | 33 | 34 | 35 | 36 | 37 | 38 | 39 | 40 | 41 | 42 | 43 | 44 | 45 | 46 | 47 | 48 | 49 | 50 | 51 |
|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|
| 0 | 174 | 97 | 166 | 66 | -1 | -1 | 71 | -1 | -1 | 172 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 1 | 27 | -1 | -1 | 36 | 48 | 92 | 31 | 187 | 185 | 3 | -1 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 2 | 25 | 114 | -1 | 117 | 110 | -1 | -1 | -1 | 114 | -1 | 1 | -1 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 3 | -1 | 136 | 175 | -1 | 113 | 72 | 123 | 118 | 28 | 186 | 0 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 4 | 72 | 74 | -1 | -1 | -1 | -1 | -1 | -1 | -1 | -1 | -1 | 29 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 5 | 10 | 44 | -1 | -1 | -1 | 121 | -1 | 80 | -1 | -1 | -1 | 48 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 6 | 129 | -1 | -1 | -1 | -1 | 92 | -1 | 100 | -1 | 49 | -1 | 184 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 7 | -1 | 80 | -1 | -1 | -1 | 186 | -1 | 16 | -1 | -1 | -1 | 102 | -1 | 143 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 8 | 118 | 70 | -1 | -1 | -1 | -1 | -1 | -1 | -1 | -1 | -1 | -1 | 152 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 9 | -1 | 28 | -1 | -1 | -1 | -1 | -1 | -1 | 132 | -1 | 185 | 178 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 10 | 59 | 104 | -1 | -1 | -1 | -1 | 22 | 52 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 11 | 32 | -1 | -1 | -1 | -1 | -1 | -1 | 92 | -1 | 174 | -1 | -1 | -1 | 154 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 12 | -1 | 39 | -1 | 93 | -1 | -1 | -1 | -1 | -1 | -1 | -1 | 11 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 13 | 49 | 125 | -1 | -1 | -1 | -1 | -1 | -1 | 35 | -1 | -1 | -1 | -1 | 166 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 14 | -1 | 19 | -1 | -1 | -1 | -1 | 118 | -1 | -1 | -1 | -1 | 21 | -1 | 163 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 15 | 68 | -1 | -1 | -1 | -1 | -1 | -1 | -1 | -1 | -1 | 63 | 81 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 16 | -1 | 87 | -1 | -1 | -1 | -1 | -1 | -1 | -1 | 177 | -1 | 135 | 64 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 17 | -1 | 158 | -1 | -1 | -1 | 23 | -1 | -1 | -1 | -1 | -1 | 9 | 6 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 18 | 186 | -1 | -1 | -1 | -1 | -1 | 6 | 46 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 19 | 58 | 42 | -1 | -1 | -1 | -1 | -1 | -1 | -1 | -1 | 156 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 20 | -1 | 76 | -1 | -1 | 61 | -1 | -1 | -1 | -1 | -1 | -1 | 153 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 |
| 21 | 157 | -1 | -1 | -1 | -1 | -1 | -1 | -1 | 175 | -1 | -1 | -1 | -1 | 67 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 |
| 22 | -1 | 20 | 52 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 |
| 23 | 106 | -1 | -1 | 86 | -1 | 95 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 |
| 24 | -1 | 182 | 153 | -1 | -1 | -1 | -1 | -1 | -1 | 64 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 |
| 25 | 45 | -1 | -1 | -1 | -1 | 21 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 |
| 26 | -1 | -1 | 67 | -1 | -1 | -1 | -1 | 137 | -1 | -1 | -1 | -1 | 55 | 85 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 |
| 27 | 103 | -1 | -1 | -1 | -1 | -1 | 50 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 |
| 28 | -1 | 70 | 111 | -1 | -1 | 168 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 |
| 29 | 110 | -1 | -1 | -1 | 17 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 |
| 30 | -1 | -1 | 120 | -1 | -1 | 154 | -1 | 52 | -1 | 56 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 |
| 31 | -1 | 3 | -1 | -1 | -1 | -1 | -1 | -1 | -1 | -1 | -1 | -1 | -1 | 170 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 |
| 32 | 84 | -1 | -1 | -1 | -1 | 8 | -1 | -1 | -1 | -1 | -1 | -1 | 17 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 |
| 33 | -1 | -1 | 165 | -1 | -1 | -1 | -1 | 179 | -1 | -1 | 124 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 |
| 34 | 173 | -1 | -1 | -1 | -1 | -1 | -1 | -1 | -1 | -1 | -1 | -1 | 177 | 12 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 |
| 35 | -1 | 77 | -1 | -1 | -1 | 184 | -1 | -1 | -1 | -1 | -1 | 18 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 |
| 36 | 25 | -1 | 151 | -1 | -1 | -1 | -1 | 170 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 |
| 37 | -1 | -1 | -1 | -1 | -1 | -1 | -1 | -1 | -1 | -1 | 37 | -1 | -1 | 31 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 |
| 38 | -1 | 84 | -1 | -1 | -1 | 151 | -1 | -1 | -1 | -1 | -1 | 190 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 |
| 39 | 93 | -1 | -1 | -1 | -1 | -1 | -1 | 132 | -1 | -1 | -1 | -1 | 57 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 |
| 40 | -1 | -1 | 103 | -1 | -1 | -1 | -1 | -1 | -1 | -1 | 107 | -1 | -1 | 163 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 |
| 41 | -1 | 147 | -1 | -1 | -1 | 7 | -1 | -1 | -1 | -1 | -1 | 60 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 |

**2.** Verfahren nach Anspruch 1, wobei das Verfahren nach dem Erhalten der Kontrollmatrix ferner umfasst: Durchführen von Zeilen- und Spaltenpermutationen für die Kontrollmatrix und Verwenden der Kontrollmatrix nach den Zeilen- und Spaltenpermutationen zum Durchführen der quasi-zyklischen LDPC-Codierung.

**3.** Verfahren nach Anspruch 2, wobei das Durchführen von Zeilen- und Spaltenpermutationen für die Kontrollmatrix ferner umfasst:

Durchführen von Zeilen- und Spaltenpermutationen für einen Teil der Zeilen- und/oder Spaltenelemente in der Kontrollmatrix; und/oder

Durchführen von Zeilen- und Spaltenpermutationen für alle Zeilen- und/oder Spaltenelemente in der Kontrollmatrix.

**4.** Codierungsvorrichtung, umfassend:

eine erste Einheit (11), die konfiguriert ist, um:

eine Basismatrix der Größe 42 Zeilen × 52 Spalten zu bestimmen, die als Basisgraph BG eines quasi-zyklischen Low Density Parity Check (LDPC)-Codes bezeichnet wird, wobei
jedes Element im Basisgraphen BG entweder "0" oder "l" ist,
jedes Element "0" im Basisgraphen BG einer Null-Untermatrix der Größe Z×Z in einer Kontrollmatrix des quasi-zyklischen LDPC-Codes entspricht,
jedes Element "l" im Basisgraphen BG einer kreisförmigen Permutationsmatrix (CPM) der Größe Z×Z in der Kontrollmatrix des quasi-zyklischen LDPC-Codes entspricht, und
die CPM, die einem Element "l" entspricht, das sich an der Position (x, y) im Basisgraphen BG befindet, durch kreisförmiges Verschieben einer Einheitsmatrix der Größe Z×Z um $P_{x,y}$ Mal nach rechts erhalten wird, wobei $P_{x,y} = mod(V_{x,y}, Z)$ und $V_{x,y}$ ein zyklischer Verschiebungskoeffizient ist, der dem (x, y)-ten Element in einer zyklischen Koeffizienten-Exponentialmatrix der Größe 42 × 52 entspricht, und jedes Element "0" in dem Basisgraph BG durch "-l" an der entsprechenden Position innerhalb der zyklischen Koeffizienten-Exponentialmatrix dargestellt wird;
einen Satz von Dimensionen Z von zu unterstützenden CPMs in eine Vielzahl von Untersätze gemäß a aufzuteilen, wobei $Z = a \times 2^j$, einschließlich des Untersatzes Set={3,6,12,24,48,96,192,384} für a=3 und $0 \leq j \leq 7$;
eine zyklische Koeffizienten-Exponentialmatrix für den Untersatz Set zu erstellen;
eine zweite Einheit (12), die konfiguriert ist, um die Kontrollmatrix des quasi-zyklischen LDPC-Codes durch Erweitern jedes zyklischen Koeffizienten als die entsprechende CPM gemäß der erstellten zyklischen Koeffizienten-Exponentialmatrix für den Untersatz Set und den Basisgraphen BG zu erhalten; und
eine dritte Einheit (13), die konfiguriert ist, um eine quasi-zyklische LDPC-Codierung gemäß der erhaltenen Kontrollmatrix durchzuführen;

wobei die erstellte zyklische Koeffizienten-Exponentialmatrix gezeigt wird durch:

| | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | 30 | 31 | 32 | 33 | 34 | 35 | 36 | 37 | 38 | 39 | 40 | 41 | 42 | 43 | 44 | 45 | 46 | 47 | 48 | 49 | 50 | 51 |
|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|
| 0 | 174 | 97 | 166 | 66 | -1 | -1 | 71 | -1 | -1 | 172 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 1 | 27 | -1 | -1 | 36 | 48 | 92 | 31 | 187 | 185 | 3 | -1 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 2 | 25 | 114 | -1 | 117 | 110 | -1 | -1 | -1 | 114 | -1 | 1 | -1 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 3 | -1 | 136 | 175 | -1 | 113 | 72 | 123 | 118 | 28 | 186 | 0 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 4 | 72 | 74 | -1 | -1 | -1 | -1 | -1 | -1 | -1 | -1 | -1 | 29 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 5 | 10 | 44 | -1 | -1 | -1 | 121 | -1 | 80 | -1 | -1 | -1 | 48 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 6 | 129 | -1 | -1 | -1 | -1 | 92 | -1 | 100 | -1 | 49 | -1 | 184 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 7 | -1 | 80 | -1 | -1 | -1 | 186 | -1 | 16 | -1 | -1 | -1 | 102 | -1 | 143 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 8 | 118 | 70 | -1 | -1 | -1 | -1 | -1 | -1 | -1 | -1 | -1 | -1 | 152 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 9 | -1 | 28 | -1 | -1 | -1 | -1 | -1 | -1 | 132 | -1 | 185 | 178 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 10 | 59 | 104 | -1 | -1 | -1 | -1 | 22 | 52 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 11 | 32 | -1 | -1 | -1 | -1 | -1 | -1 | 92 | -1 | 174 | -1 | -1 | -1 | 154 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 12 | -1 | 39 | -1 | 93 | -1 | -1 | -1 | -1 | -1 | -1 | -1 | 11 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 13 | 49 | 125 | -1 | -1 | -1 | -1 | -1 | -1 | 35 | -1 | -1 | -1 | -1 | 166 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 14 | -1 | 19 | -1 | -1 | -1 | -1 | 118 | -1 | -1 | -1 | -1 | 21 | -1 | 163 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 15 | 68 | -1 | -1 | -1 | -1 | -1 | -1 | -1 | -1 | -1 | 63 | 81 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 16 | -1 | 87 | -1 | -1 | -1 | -1 | -1 | -1 | -1 | 177 | -1 | 135 | 64 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 17 | -1 | 158 | -1 | -1 | -1 | 23 | -1 | -1 | -1 | -1 | -1 | 9 | 6 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 18 | 186 | -1 | -1 | -1 | -1 | -1 | 6 | 46 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 19 | 58 | 42 | -1 | -1 | -1 | -1 | -1 | -1 | -1 | -1 | 156 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 20 | -1 | 76 | -1 | -1 | 61 | -1 | -1 | -1 | -1 | -1 | -1 | 153 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 |
| 21 | 157 | -1 | -1 | -1 | -1 | -1 | -1 | -1 | 175 | -1 | -1 | -1 | -1 | 67 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 |
| 22 | -1 | 20 | 52 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 |
| 23 | 106 | -1 | -1 | 86 | -1 | 95 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 |
| 24 | -1 | 182 | 153 | -1 | -1 | -1 | -1 | -1 | -1 | 64 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 |
| 25 | 45 | -1 | -1 | -1 | -1 | 21 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 |
| 26 | -1 | -1 | 67 | -1 | -1 | -1 | -1 | 137 | -1 | -1 | -1 | -1 | 55 | 85 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 |
| 27 | 103 | -1 | -1 | -1 | -1 | -1 | 50 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 |
| 28 | -1 | 70 | 111 | -1 | -1 | 168 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 |
| 29 | 110 | -1 | -1 | -1 | 17 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 |
| 30 | -1 | -1 | 120 | -1 | -1 | 154 | -1 | 52 | -1 | 56 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 |
| 31 | -1 | 3 | -1 | -1 | -1 | -1 | -1 | -1 | -1 | -1 | -1 | -1 | -1 | 170 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 |
| 32 | 84 | -1 | -1 | -1 | -1 | 8 | -1 | -1 | -1 | -1 | -1 | -1 | 17 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 |
| 33 | -1 | -1 | 165 | -1 | -1 | -1 | -1 | 179 | -1 | -1 | 124 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 |
| 34 | 173 | -1 | -1 | -1 | -1 | -1 | -1 | -1 | -1 | -1 | -1 | -1 | 177 | 12 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 |
| 35 | -1 | 77 | -1 | -1 | -1 | 184 | -1 | -1 | -1 | -1 | -1 | 18 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 |
| 36 | 25 | -1 | 151 | -1 | -1 | -1 | -1 | 170 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 |
| 37 | -1 | -1 | -1 | -1 | -1 | -1 | -1 | -1 | -1 | -1 | 37 | -1 | -1 | 31 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 |
| 38 | -1 | 84 | -1 | -1 | -1 | 151 | -1 | -1 | -1 | -1 | -1 | 190 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 |
| 39 | 93 | -1 | -1 | -1 | -1 | -1 | -1 | 132 | -1 | -1 | -1 | -1 | 57 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 |
| 40 | -1 | -1 | 103 | -1 | -1 | -1 | -1 | -1 | -1 | -1 | 107 | -1 | -1 | 163 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 |
| 41 | -1 | 147 | -1 | -1 | -1 | 7 | -1 | -1 | -1 | -1 | -1 | 60 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 |

5. Computerspeichermedium, das computerausführbare Anweisungen speichert, die konfiguriert sind, um einen Computer zu veranlassen, das Verfahren nach einem der Ansprüche 1 bis 3 durchzuführen.

## Revendications

1. Procédé de codage, comprenant :

la détermination d'une matrice de base d'une taille de 42 lignes × 52 colonnes désignée graphe de base BG d'un code de contrôle de parité de faible densité, LDPC, quasi-cyclique, où

chaque élément dans le graphe de base BG est soit "0", soit "1"",
chaque élément "0" dans le graphe de base BG correspond à une sous-matrice entièrement de zéros de taille ZxZ dans une matrice de contrôle de parité du code LDPC quasi-cyclique,
chaque élément "1" du graphe de base BG correspond à une matrice de permutation circulaire, CPM, de taille ZxZ dans la matrice de contrôle de parité du code LDPC quasi-cyclique, et
la CPM correspondant à un élément "1" situé à la position (x, y) dans le graphe de base BG est obtenue en décalant circulairement une matrice unitaire de taille ZxZ vers la droite $P_{x,y}$ fois, dans lequel $P_{x,y}$ = $mod(V_{xy}, Z)$, et $V_{x,y}$ est un coefficient de décalage cyclique correspondant au (x, y)-ième élément dans une matrice d'exposants de coefficients cycliques de taille 42 $\times$ 52 et chaque élément "0" dans le graphe de base BG est représenté par "-1" à la position correspondante dans la matrice d'exposants de coefficients cycliques ;

la division d'un ensemble de dimensions Z de CPM à prendre en charge en une pluralité de sous-ensembles selon a, dans lequel $Z=a\times 2^J$, comportant un sous-ensemble Set={3,6,12,24,48,96,192,384} pour a=3 et $0 \leq i \leq 7$ ;
la construction d'une matrice d'exposants de coefficients cycliques pour le sous-ensemble Set ;
l'obtention de la matrice de contrôle de parité du code LDPC quasi cyclique en étendant chaque coefficient cyclique en tant que MPC correspondante conformément à la matrice d'exposants de coefficients cycliques construite pour le sous-ensemble Set et le graphique de base BG ; et
la réalisation d'un codage LDPC quasi-cyclique conformément à la matrice de contrôle de parité obtenue ;
dans lequel la matrice d'exposants de coefficients cycliques construite est représentée par:

| | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | 30 | 31 | 32 | 33 | 34 | 35 | 36 | 37 | 38 | 39 | 40 | 41 | 42 | 43 | 44 | 45 | 46 | 47 | 48 | 49 | 50 | 51 |
|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|
| 0 | 174 | 97 | 166 | 66 | -1 | -1 | 71 | -1 | -1 | 172 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 1 | 27 | -1 | -1 | 36 | 48 | 92 | 31 | 187 | 185 | 3 | -1 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 2 | 25 | 114 | -1 | 117 | 110 | -1 | -1 | -1 | 114 | -1 | 1 | -1 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 3 | -1 | 136 | 175 | -1 | 113 | 72 | 123 | 118 | 28 | 186 | 0 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 4 | 72 | 74 | -1 | -1 | -1 | -1 | -1 | -1 | -1 | -1 | -1 | 29 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 5 | 10 | 44 | -1 | -1 | -1 | 121 | -1 | 80 | -1 | -1 | -1 | 48 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 6 | 129 | -1 | -1 | -1 | -1 | 92 | -1 | 100 | -1 | 49 | -1 | 184 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 7 | -1 | 80 | -1 | -1 | -1 | 186 | -1 | 16 | -1 | -1 | -1 | 102 | -1 | 143 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 8 | 118 | 70 | -1 | -1 | -1 | -1 | -1 | -1 | -1 | -1 | -1 | -1 | 152 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 9 | -1 | 28 | -1 | -1 | -1 | -1 | -1 | -1 | 132 | -1 | 185 | 178 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 10 | 59 | 104 | -1 | -1 | -1 | -1 | 22 | 52 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 11 | 32 | -1 | -1 | -1 | -1 | -1 | -1 | 92 | -1 | 174 | -1 | -1 | -1 | 154 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 12 | -1 | 39 | -1 | 53 | -1 | -1 | -1 | -1 | -1 | -1 | -1 | 11 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 13 | 49 | 125 | -1 | -1 | -1 | -1 | -1 | -1 | 35 | -1 | -1 | -1 | -1 | 166 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 14 | -1 | 19 | -1 | -1 | -1 | -1 | 118 | -1 | -1 | -1 | -1 | 21 | -1 | 163 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 15 | 68 | -1 | -1 | -1 | -1 | -1 | -1 | -1 | -1 | -1 | 63 | 81 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 16 | -1 | 87 | -1 | -1 | -1 | -1 | -1 | -1 | -1 | 177 | -1 | 135 | 64 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 17 | -1 | 158 | -1 | -1 | -1 | 23 | -1 | -1 | -1 | -1 | -1 | 9 | 6 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 18 | 186 | -1 | -1 | -1 | -1 | -1 | 6 | 46 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 19 | 58 | 42 | -1 | -1 | -1 | -1 | -1 | -1 | -1 | -1 | 156 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 20 | -1 | 76 | -1 | -1 | 61 | -1 | -1 | -1 | -1 | -1 | -1 | 153 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 |
| 21 | 157 | -1 | -1 | -1 | -1 | -1 | -1 | -1 | 175 | -1 | -1 | -1 | -1 | 67 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 |
| 22 | -1 | 20 | 52 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 |
| 23 | 106 | -1 | -1 | 86 | -1 | 95 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 |
| 24 | -1 | 182 | 153 | -1 | -1 | -1 | -1 | -1 | -1 | 64 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 |
| 25 | 45 | -1 | -1 | -1 | -1 | 21 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 |
| 26 | -1 | -1 | 67 | -1 | -1 | -1 | -1 | 137 | -1 | -1 | -1 | -1 | 55 | 85 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 |
| 27 | 103 | -1 | -1 | -1 | -1 | -1 | 50 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 |
| 28 | -1 | 70 | 111 | -1 | -1 | 168 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 |
| 29 | 110 | -1 | -1 | -1 | 17 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 |
| 30 | -1 | -1 | 120 | -1 | -1 | 154 | -1 | 52 | -1 | 56 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 |
| 31 | -1 | 3 | -1 | -1 | -1 | -1 | -1 | -1 | -1 | -1 | -1 | -1 | -1 | 170 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 |
| 32 | 84 | -1 | -1 | -1 | -1 | 8 | -1 | -1 | -1 | -1 | -1 | -1 | 17 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 |
| 33 | -1 | -1 | 165 | -1 | -1 | -1 | -1 | 179 | -1 | -1 | 124 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 |
| 34 | 173 | -1 | -1 | -1 | -1 | -1 | -1 | -1 | -1 | -1 | -1 | -1 | 177 | 12 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 |
| 35 | -1 | 77 | -1 | -1 | -1 | 184 | -1 | -1 | -1 | -1 | -1 | 18 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 |
| 36 | 25 | -1 | 151 | -1 | -1 | -1 | -1 | 170 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 |
| 37 | -1 | -1 | -1 | -1 | -1 | -1 | -1 | -1 | -1 | -1 | 37 | -1 | -1 | 31 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 |
| 38 | -1 | 84 | -1 | -1 | -1 | 151 | -1 | -1 | -1 | -1 | -1 | 190 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 |
| 39 | 93 | -1 | -1 | -1 | -1 | -1 | -1 | 132 | -1 | -1 | -1 | -1 | 57 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 |
| 40 | -1 | -1 | 103 | -1 | -1 | -1 | -1 | -1 | -1 | -1 | 107 | -1 | -1 | 163 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 |
| 41 | -1 | 147 | -1 | -1 | -1 | 7 | -1 | -1 | -1 | -1 | -1 | 60 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 |

2. Procédé selon la revendication 1, le procédé comprenant en outre, après l'obtention de la matrice de vérification de parité : la réalisation de permutations de lignes et de colonnes de la matrice de contrôle de parité, et l'utilisation de la matrice de contrôle de parité après les permutations de lignes et de colonnes pour réaliser le codage LDPC quasi-cyclique.

**3.** Procédé selon la revendication 2, dans lequel la réalisation de permutations de lignes et de colonnes de la matrice de contrôle de parité comprend en outre :

la réalisation de permutations de lignes et de colonnes pour une partie d'éléments de ligne et/ou de colonne dans la matrice de contrôle de parité ; et/ou
la réalisation de permutations de lignes et de colonnes pour tous les éléments de ligne et/ou de colonne dans la matrice de contrôle de parité.

**4.** Appareil de codage comprenant :

une première unité (11), configurée pour :

déterminer une matrice de base d'une taille de 42 lignes $\times$ 52 colonnes désignée graphe de base BG d'un code de contrôle de parité de faible densité, LDPC, quasi-cyclique, où

chaque élément dans le graphe de base BG est soit "0", soit "1"",
chaque élément "0" dans le graphe de base BG correspond à une sous-matrice entièrement de zéros de taille ZxZ dans une matrice de contrôle de parité du code LDPC quasi-cyclique,
chaque élément "1" du graphe de base BG correspond à une matrice de permutation circulaire, CPM, de taille ZxZ dans la matrice de contrôle de parité du code LDPC quasi-cyclique, et
la CPM correspondant à un élément "1" situé à la position (x, y) dans le graphe de base BG est obtenue en décalant circulairement une matrice unitaire de taille ZxZ vers la droite $P_{x,y}$ fois, dans lequel $P_{x,y} = mod(V_{xy}, Z)$, et $V_{x,y}$ est un coefficient de décalage cyclique correspondant au (x, y)-ième élément dans une matrice d'exposants de coefficients cycliques de taille 42 $\times$ 52 et chaque élément "0" dans le graphe de base BG est représenté par "-1" à la position correspondante dans la matrice d'exposants de coefficients cycliques ;

diviser un ensemble de dimensions Z de CPM à prendre en charge en une pluralité de sous-ensembles selon a, dans lequel $Z=a\times 2^J$, comportant un sous-ensemble Set={3,6,12,24,48,96,192,384} pour a=3 et $0 \leq i \leq 7$ ;
construire une matrice d'exposants de coefficients cycliques pour le sous-ensemble Set ;
une deuxième unité (12) configurée pour obtenir la matrice de contrôle de parité du code LDPC quasi cyclique en étendant chaque coefficient cyclique en tant que CPM correspondante conformément à la matrice d'exposants de coefficients cycliques construite pour le sous-ensemble Set et le graphique de base BG ; et
une troisième unité (13) configurée pour réaliser un codage LDPC quasi-cyclique conformément à la matrice de contrôle de parité obtenue ;

dans lequel la matrice d'exposants de coefficients cycliques construite est représentée par :

| | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | 30 | 31 | 32 | 33 | 34 | 35 | 36 | 37 | 38 | 39 | 40 | 41 | 42 | 43 | 44 | 45 | 46 | 47 | 48 | 49 | 50 | 51 |
|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|
| 0 | 174 | 97 | 166 | 66 | -1 | -1 | 71 | -1 | -1 | 172 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 1 | 27 | -1 | -1 | 36 | 48 | 92 | 31 | 187 | 185 | 3 | -1 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 2 | 25 | 114 | -1 | 117 | 110 | -1 | -1 | -1 | 114 | -1 | 1 | -1 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 3 | -1 | 136 | 175 | -1 | 113 | 72 | 123 | 118 | 28 | 186 | 0 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 4 | 72 | 74 | -1 | -1 | -1 | -1 | -1 | -1 | -1 | -1 | -1 | 29 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 5 | 10 | 44 | -1 | -1 | -1 | 121 | -1 | 80 | -1 | -1 | -1 | 48 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 6 | 129 | -1 | -1 | -1 | -1 | 92 | -1 | 100 | -1 | 49 | -1 | 184 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 7 | -1 | 80 | -1 | -1 | -1 | 186 | -1 | 16 | -1 | -1 | -1 | 102 | -1 | 143 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 8 | 118 | 70 | -1 | -1 | -1 | -1 | -1 | -1 | -1 | -1 | -1 | -1 | 152 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 9 | -1 | 28 | -1 | -1 | -1 | -1 | -1 | -1 | 132 | -1 | 185 | 178 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 10 | 59 | 104 | -1 | -1 | -1 | -1 | 22 | 52 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 11 | 32 | -1 | -1 | -1 | -1 | -1 | -1 | 92 | -1 | 174 | -1 | -1 | -1 | 154 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 12 | -1 | 39 | -1 | 93 | -1 | -1 | -1 | -1 | -1 | -1 | -1 | 11 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 13 | 49 | 125 | -1 | -1 | -1 | -1 | -1 | -1 | 35 | -1 | -1 | -1 | -1 | 166 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 14 | -1 | 19 | -1 | -1 | -1 | -1 | 118 | -1 | -1 | -1 | -1 | 21 | -1 | 163 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 15 | 68 | -1 | -1 | -1 | -1 | -1 | -1 | -1 | -1 | -1 | 63 | 81 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 16 | -1 | 87 | -1 | -1 | -1 | -1 | -1 | -1 | -1 | 177 | -1 | 135 | 64 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 17 | -1 | 158 | -1 | -1 | -1 | 23 | -1 | -1 | -1 | -1 | -1 | 9 | 6 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 18 | 186 | -1 | -1 | -1 | -1 | -1 | 6 | 46 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 19 | 58 | 42 | -1 | -1 | -1 | -1 | -1 | -1 | -1 | -1 | 156 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 20 | -1 | 76 | -1 | -1 | 61 | -1 | -1 | -1 | -1 | -1 | -1 | 153 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 |
| 21 | 157 | -1 | -1 | -1 | -1 | -1 | -1 | -1 | 175 | -1 | -1 | -1 | -1 | 67 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 |
| 22 | -1 | 20 | 52 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 |
| 23 | 106 | -1 | -1 | 86 | -1 | 95 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 |
| 24 | -1 | 182 | 153 | -1 | -1 | -1 | -1 | -1 | -1 | 64 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 |
| 25 | 45 | -1 | -1 | -1 | -1 | 21 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 |
| 26 | -1 | -1 | 67 | -1 | -1 | -1 | -1 | 137 | -1 | -1 | -1 | -1 | 55 | 85 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 |
| 27 | 103 | -1 | -1 | -1 | -1 | -1 | 50 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 |
| 28 | -1 | 70 | 111 | -1 | -1 | 168 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 |
| 29 | 110 | -1 | -1 | -1 | 17 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 |
| 30 | -1 | -1 | 120 | -1 | -1 | 154 | -1 | 52 | -1 | 56 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 |
| 31 | -1 | 3 | -1 | -1 | -1 | -1 | -1 | -1 | -1 | -1 | -1 | -1 | -1 | 170 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 |
| 32 | 84 | -1 | -1 | -1 | -1 | 8 | -1 | -1 | -1 | -1 | -1 | -1 | 17 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 |
| 33 | -1 | -1 | 165 | -1 | -1 | -1 | -1 | 179 | -1 | -1 | 124 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 |
| 34 | 173 | -1 | -1 | -1 | -1 | -1 | -1 | -1 | -1 | -1 | -1 | -1 | 177 | 12 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 |
| 35 | -1 | 77 | -1 | -1 | -1 | 184 | -1 | -1 | -1 | -1 | -1 | 18 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 |
| 36 | 25 | -1 | 151 | -1 | -1 | -1 | -1 | 170 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 |
| 37 | -1 | -1 | -1 | -1 | -1 | -1 | -1 | -1 | -1 | -1 | 37 | -1 | -1 | 31 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 |
| 38 | -1 | 84 | -1 | -1 | -1 | 151 | -1 | -1 | -1 | -1 | -1 | 190 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 |
| 39 | 93 | -1 | -1 | -1 | -1 | -1 | -1 | 132 | -1 | -1 | -1 | -1 | 57 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 |
| 40 | -1 | -1 | 103 | -1 | -1 | -1 | -1 | -1 | -1 | -1 | 107 | -1 | -1 | 163 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 |
| 41 | -1 | 147 | -1 | -1 | -1 | 7 | -1 | -1 | -1 | -1 | -1 | 60 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 |

.

5. Support de stockage informatique, stockant des instructions exécutables configurées pour amener un ordinateur à réaliser le procédé selon l’une quelconque des revendications 1 à 3.

$$B=\begin{bmatrix}1 & 0 & \cdots & 1\\ 0 & 1 & \cdots & 1\\ \vdots & \vdots & \ddots & \vdots\\ 1 & 1 & \cdots & 0\end{bmatrix}_{\rho\times c}$$

Fig. 1

$$P=\begin{bmatrix}0 & 1 & 0 & \cdots & 0\\ 0 & 0 & 1 & \cdots & 0\\ \vdots & \vdots & \vdots & \vdots & \vdots\\ 0 & 0 & 0 & \cdots & 1\\ 1 & 0 & 0 & \cdots & 0\end{bmatrix}_{z\times z}$$

Fig. 2

$$P^0=\begin{bmatrix}1&0&0&0&0&0&0&0\\0&1&0&0&0&0&0&0\\0&0&1&0&0&0&0&0\\0&0&0&1&0&0&0&0\\0&0&0&0&1&0&0&0\\0&0&0&0&0&1&0&0\\0&0&0&0&0&0&1&0\\0&0&0&0&0&0&0&1\end{bmatrix},P=P^1=\begin{bmatrix}0&1&0&0&0&0&0&0\\0&0&1&0&0&0&0&0\\0&0&0&1&0&0&0&0\\0&0&0&0&1&0&0&0\\0&0&0&0&0&1&0&0\\0&0&0&0&0&0&1&0\\0&0&0&0&0&0&0&1\\1&0&0&0&0&0&0&0\end{bmatrix},P^5=\begin{bmatrix}0&0&0&0&0&1&0&0\\0&0&0&0&0&0&1&0\\0&0&0&0&0&0&0&1\\1&0&0&0&0&0&0&0\\0&1&0&0&0&0&0&0\\0&0&1&0&0&0&0&0\\0&0&0&1&0&0&0&0\\0&0&0&0&1&0&0&0\end{bmatrix}$$

Fig. 3

$$BG = \begin{bmatrix} 1 & 1 & 1 & 1 & 0 & 0 \\ 0 & 1 & 1 & 1 & 1 & 0 \\ 0 & 0 & 1 & 1 & 1 & 1 \end{bmatrix} \qquad SEM = \begin{bmatrix} 3 & 4 & 7 & 0 & -1 & -1 \\ -1 & 3 & 4 & 7 & 0 & -1 \\ -1 & -1 & 3 & 4 & 7 & 0 \end{bmatrix}$$

Fig. 4

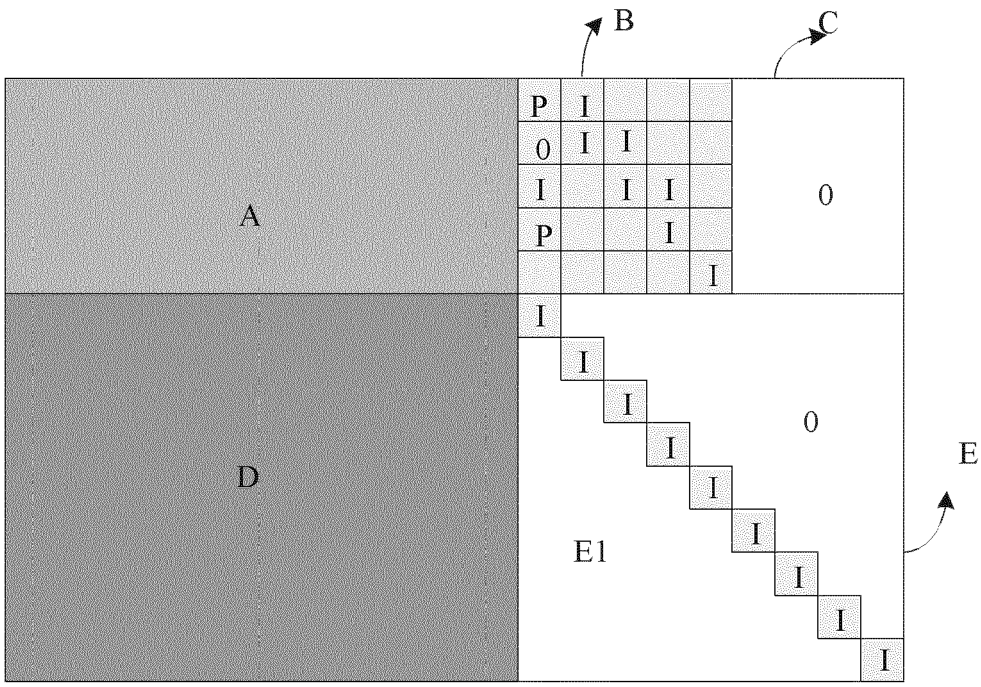


Fig. 5

| Z | | a | | | | | | | |
|---|---|---|---|---|---|---|---|---|---|
| | | 2 | 3 | 5 | 7 | 9 | 11 | 13 | 15 |
| j | 0 | 2 | 3 | 5 | 7 | 9 | 11 | 13 | 15 |
| | 1 | 4 | 6 | 10 | 14 | 18 | 22 | 26 | 30 |
| | 2 | 8 | 12 | 20 | 28 | 36 | 44 | 52 | 60 |
| | 3 | 16 | 24 | 40 | 56 | 72 | 88 | 104 | 120 |
| | 4 | 32 | 48 | 80 | 112 | 144 | 176 | 208 | 240 |
| | 5 | 64 | 96 | 160 | 224 | 288 | 352 | | |
| | 6 | 128 | 192 | 320 | | | | | |
| | 7 | 256 | 384 | | | | | | |

Fig. 6

| |0|1|2|3|4|5|6|7|8|9|10|11|12|13|14|15|16|17|18|19|20|21|22|23|24|25|26|27|28|29|30|31|32|33|34|35|36|37|38|39|40|41|42|43|44|45|46|47|48|49|50|51|
|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|
|0|1|1|1|1|0|0|1|0|0|1|1|1|0|0|0|0|0|0|0|0|0|0|0|0|0|0|0|0|0|0|0|0|0|0|0|0|0|0|0|0|0|0|0|0|0|0|0|0|0|0|0|0|
|1|1|0|0|1|1|1|1|1|1|1|0|1|1|0|0|0|0|0|0|0|0|0|0|0|0|0|0|0|0|0|0|0|0|0|0|0|0|0|0|0|0|0|0|0|0|0|0|0|0|0|0|0|
|2|1|1|0|1|1|0|0|0|1|0|1|0|1|1|0|0|0|0|0|0|0|0|0|0|0|0|0|0|0|0|0|0|0|0|0|0|0|0|0|0|0|0|0|0|0|0|0|0|0|0|0|0|
|3|0|1|1|0|1|1|1|1|1|1|1|0|0|1|0|0|0|0|0|0|0|0|0|0|0|0|0|0|0|0|0|0|0|0|0|0|0|0|0|0|0|0|0|0|0|0|0|0|0|0|0|0|
|4|1|1|0|0|0|0|0|0|0|0|0|1|0|0|1|0|0|0|0|0|0|0|0|0|0|0|0|0|0|0|0|0|0|0|0|0|0|0|0|0|0|0|0|0|0|0|0|0|0|0|0|0|
|5|1|1|0|0|0|1|0|1|0|0|0|1|0|0|0|1|0|0|0|0|0|0|0|0|0|0|0|0|0|0|0|0|0|0|0|0|0|0|0|0|0|0|0|0|0|0|0|0|0|0|0|0|
|6|1|0|0|0|0|1|0|1|0|1|0|1|0|0|0|0|1|0|0|0|0|0|0|0|0|0|0|0|0|0|0|0|0|0|0|0|0|0|0|0|0|0|0|0|0|0|0|0|0|0|0|0|
|7|0|1|0|0|0|1|0|1|0|0|0|1|0|1|0|0|0|1|0|0|0|0|0|0|0|0|0|0|0|0|0|0|0|0|0|0|0|0|0|0|0|0|0|0|0|0|0|0|0|0|0|0|
|8|1|1|0|0|0|0|0|0|0|0|0|0|1|0|0|0|0|0|1|0|0|0|0|0|0|0|0|0|0|0|0|0|0|0|0|0|0|0|0|0|0|0|0|0|0|0|0|0|0|0|0|0|
|9|0|1|0|0|0|0|0|0|1|0|1|1|0|0|0|0|0|0|0|1|0|0|0|0|0|0|0|0|0|0|0|0|0|0|0|0|0|0|0|0|0|0|0|0|0|0|0|0|0|0|0|0|
|10|1|1|0|0|0|0|1|1|0|0|0|0|0|0|0|0|0|0|0|0|1|0|0|0|0|0|0|0|0|0|0|0|0|0|0|0|0|0|0|0|0|0|0|0|0|0|0|0|0|0|0|0|
|11|1|0|0|0|0|0|0|1|0|1|0|0|0|1|0|0|0|0|0|0|0|1|0|0|0|0|0|0|0|0|0|0|0|0|0|0|0|0|0|0|0|0|0|0|0|0|0|0|0|0|0|0|
|12|0|1|0|1|0|0|0|0|0|0|0|1|0|0|0|0|0|0|0|0|0|0|1|0|0|0|0|0|0|0|0|0|0|0|0|0|0|0|0|0|0|0|0|0|0|0|0|0|0|0|0|0|
|13|1|1|0|0|0|0|0|0|1|0|0|0|0|1|0|0|0|0|0|0|0|0|0|1|0|0|0|0|0|0|0|0|0|0|0|0|0|0|0|0|0|0|0|0|0|0|0|0|0|0|0|0|
|14|0|1|0|0|0|0|1|0|0|0|0|1|0|1|0|0|0|0|0|0|0|0|0|0|1|0|0|0|0|0|0|0|0|0|0|0|0|0|0|0|0|0|0|0|0|0|0|0|0|0|0|0|
|15|1|0|0|0|0|0|0|0|0|0|1|1|0|0|0|0|0|0|0|0|0|0|0|0|0|1|0|0|0|0|0|0|0|0|0|0|0|0|0|0|0|0|0|0|0|0|0|0|0|0|0|0|
|16|0|1|0|0|0|0|0|0|0|1|0|1|1|0|0|0|0|0|0|0|0|0|0|0|0|0|1|0|0|0|0|0|0|0|0|0|0|0|0|0|0|0|0|0|0|0|0|0|0|0|0|0|
|17|0|1|0|0|0|1|0|0|0|0|0|1|1|0|0|0|0|0|0|0|0|0|0|0|0|0|0|1|0|0|0|0|0|0|0|0|0|0|0|0|0|0|0|0|0|0|0|0|0|0|0|0|
|18|1|0|0|0|0|0|1|1|0|0|0|0|0|0|0|0|0|0|0|0|0|0|0|0|0|0|0|0|1|0|0|0|0|0|0|0|0|0|0|0|0|0|0|0|0|0|0|0|0|0|0|0|
|19|1|1|0|0|0|0|0|0|0|0|1|0|0|0|0|0|0|0|0|0|0|0|0|0|0|0|0|0|0|1|0|0|0|0|0|0|0|0|0|0|0|0|0|0|0|0|0|0|0|0|0|0|
|20|0|1|0|0|1|0|0|0|0|0|0|1|0|0|0|0|0|0|0|0|0|0|0|0|0|0|0|0|0|0|1|0|0|0|0|0|0|0|0|0|0|0|0|0|0|0|0|0|0|0|0|0|
|21|1|0|0|0|0|0|0|0|1|0|0|0|0|1|0|0|0|0|0|0|0|0|0|0|0|0|0|0|0|0|0|1|0|0|0|0|0|0|0|0|0|0|0|0|0|0|0|0|0|0|0|0|
|22|0|1|1|0|0|0|0|0|0|0|0|0|0|0|0|0|0|0|0|0|0|0|0|0|0|0|0|0|0|0|0|0|1|0|0|0|0|0|0|0|0|0|0|0|0|0|0|0|0|0|0|0|
|23|1|0|0|1|0|1|0|0|0|0|0|0|0|0|0|0|0|0|0|0|0|0|0|0|0|0|0|0|0|0|0|0|0|1|0|0|0|0|0|0|0|0|0|0|0|0|0|0|0|0|0|0|
|24|0|1|1|0|0|0|0|0|0|1|0|0|0|0|0|0|0|0|0|0|0|0|0|0|0|0|0|0|0|0|0|0|0|0|1|0|0|0|0|0|0|0|0|0|0|0|0|0|0|0|0|0|
|25|1|0|0|0|0|1|0|0|0|0|0|0|0|0|0|0|0|0|0|0|0|0|0|0|0|0|0|0|0|0|0|0|0|0|0|1|0|0|0|0|0|0|0|0|0|0|0|0|0|0|0|0|
|26|0|0|1|0|0|0|0|1|0|0|0|0|1|1|0|0|0|0|0|0|0|0|0|0|0|0|0|0|0|0|0|0|0|0|0|0|1|0|0|0|0|0|0|0|0|0|0|0|0|0|0|0|
|27|1|0|0|0|0|0|1|0|0|0|0|0|0|0|0|0|0|0|0|0|0|0|0|0|0|0|0|0|0|0|0|0|0|0|0|0|0|1|0|0|0|0|0|0|0|0|0|0|0|0|0|0|
|28|0|1|1|0|0|1|0|0|0|0|0|0|0|0|0|0|0|0|0|0|0|0|0|0|0|0|0|0|0|0|0|0|0|0|0|0|0|0|1|0|0|0|0|0|0|0|0|0|0|0|0|0|
|29|1|0|0|0|1|0|0|0|0|0|0|0|0|0|0|0|0|0|0|0|0|0|0|0|0|0|0|0|0|0|0|0|0|0|0|0|0|0|0|1|0|0|0|0|0|0|0|0|0|0|0|0|
|30|0|0|1|0|0|1|0|1|0|1|0|0|0|0|0|0|0|0|0|0|0|0|0|0|0|0|0|0|0|0|0|0|0|0|0|0|0|0|0|0|1|0|0|0|0|0|0|0|0|0|0|0|
|31|0|1|0|0|0|0|0|0|0|0|0|0|0|1|0|0|0|0|0|0|0|0|0|0|0|0|0|0|0|0|0|0|0|0|0|0|0|0|0|0|0|1|0|0|0|0|0|0|0|0|0|0|
|32|1|0|0|0|0|1|0|0|0|0|0|0|1|0|0|0|0|0|0|0|0|0|0|0|0|0|0|0|0|0|0|0|0|0|0|0|0|0|0|0|0|0|1|0|0|0|0|0|0|0|0|0|
|33|0|0|1|0|0|0|0|1|0|0|1|0|0|0|0|0|0|0|0|0|0|0|0|0|0|0|0|0|0|0|0|0|0|0|0|0|0|0|0|0|0|0|0|1|0|0|0|0|0|0|0|0|
|34|1|0|0|0|0|0|0|0|0|0|0|0|1|1|0|0|0|0|0|0|0|0|0|0|0|0|0|0|0|0|0|0|0|0|0|0|0|0|0|0|0|0|0|0|1|0|0|0|0|0|0|0|
|35|0|1|0|0|0|1|0|0|0|0|0|1|0|0|0|0|0|0|0|0|0|0|0|0|0|0|0|0|0|0|0|0|0|0|0|0|0|0|0|0|0|0|0|0|0|1|0|0|0|0|0|0|
|36|1|0|1|0|0|0|0|1|0|0|0|0|0|0|0|0|0|0|0|0|0|0|0|0|0|0|0|0|0|0|0|0|0|0|0|0|0|0|0|0|0|0|0|0|0|0|1|0|0|0|0|0|
|37|0|0|0|0|0|0|0|0|0|0|1|0|0|1|0|0|0|0|0|0|0|0|0|0|0|0|0|0|0|0|0|0|0|0|0|0|0|0|0|0|0|0|0|0|0|0|0|1|0|0|0|0|
|38|0|1|0|0|0|1|0|0|0|0|0|1|0|0|0|0|0|0|0|0|0|0|0|0|0|0|0|0|0|0|0|0|0|0|0|0|0|0|0|0|0|0|0|0|0|0|0|0|1|0|0|0|
|39|1|0|0|0|0|0|0|1|0|0|0|0|1|0|0|0|0|0|0|0|0|0|0|0|0|0|0|0|0|0|0|0|0|0|0|0|0|0|0|0|0|0|0|0|0|0|0|0|0|1|0|0|
|40|0|0|1|0|0|0|0|0|0|0|1|0|0|1|0|0|0|0|0|0|0|0|0|0|0|0|0|0|0|0|0|0|0|0|0|0|0|0|0|0|0|0|0|0|0|0|0|0|0|0|1|0|
|41|0|1|0|0|0|1|0|0|0|0|0|1|0|0|0|0|0|0|0|0|0|0|0|0|0|0|0|0|0|0|0|0|0|0|0|0|0|0|0|0|0|0|0|0|0|0|0|0|0|0|0|1|

Fig.7

| | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | 30 | 31 | 32 | 33 | 34 | 35 | 36 | 37 | 38 | 39 | 40 | 41 | 42 | 43 | 44 | 45 | 46 | 47 | 48 | 49 | 50 | 51 |
|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|
| 0 | 9 | 32 | 147 | 28 | -1 | -1 | 85 | -1 | -1 | 13 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 1 | 167 | -1 | -1 | 168 | 195 | 165 | 122 | 43 | 214 | 60 | -1 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 2 | 176 | 29 | -1 | 110 | 250 | -1 | -1 | -1 | 200 | -1 | 1 | -1 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 3 | -1 | 35 | 81 | -1 | 212 | 208 | 40 | 15 | 0 | 192 | 0 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 4 | 12 | 20 | -1 | -1 | -1 | -1 | -1 | -1 | -1 | -1 | -1 | 218 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 5 | 234 | 240 | -1 | -1 | -1 | 124 | -1 | 153 | -1 | -1 | -1 | 34 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 6 | 95 | -1 | -1 | -1 | -1 | 238 | -1 | 10 | -1 | 102 | -1 | 250 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 7 | -1 | 83 | -1 | -1 | -1 | 225 | -1 | 110 | -1 | -1 | -1 | 192 | -1 | 212 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 8 | 203 | 239 | -1 | -1 | -1 | -1 | -1 | -1 | -1 | -1 | -1 | -1 | 127 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 9 | -1 | 151 | -1 | -1 | -1 | -1 | -1 | -1 | 230 | -1 | 62 | 51 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 10 | 215 | 2 | -1 | -1 | -1 | -1 | 34 | 227 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 11 | 196 | -1 | -1 | -1 | -1 | -1 | -1 | 238 | -1 | 181 | -1 | -1 | -1 | 183 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 12 | -1 | 15 | -1 | 166 | -1 | -1 | -1 | -1 | -1 | -1 | -1 | 8 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 13 | 16 | 201 | -1 | -1 | -1 | -1 | -1 | -1 | 162 | -1 | -1 | -1 | -1 | 159 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 14 | -1 | 134 | -1 | -1 | -1 | -1 | 69 | -1 | -1 | -1 | -1 | 165 | -1 | 56 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 15 | 97 | -1 | -1 | -1 | -1 | -1 | -1 | -1 | -1 | -1 | 102 | 125 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 16 | -1 | 195 | -1 | -1 | -1 | -1 | -1 | -1 | -1 | 8 | -1 | 110 | 45 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 17 | -1 | 191 | -1 | -1 | -1 | 23 | -1 | -1 | -1 | -1 | -1 | 228 | 54 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 18 | 95 | -1 | -1 | -1 | -1 | -1 | 78 | 20 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 19 | 147 | 109 | -1 | -1 | -1 | -1 | -1 | -1 | -1 | -1 | 166 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 20 | -1 | 68 | -1 | -1 | 179 | -1 | -1 | -1 | -1 | -1 | -1 | 69 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 |
| 21 | 14 | -1 | -1 | -1 | -1 | -1 | -1 | -1 | 98 | -1 | -1 | -1 | -1 | 116 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 |
| 22 | -1 | 64 | 237 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 |
| 23 | 39 | -1 | -1 | 241 | -1 | 43 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 |
| 24 | -1 | 7 | 176 | -1 | -1 | -1 | -1 | -1 | -1 | 145 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 |
| 25 | 189 | -1 | -1 | -1 | -1 | 166 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 |
| 26 | -1 | -1 | 196 | -1 | -1 | -1 | -1 | 217 | -1 | -1 | -1 | -1 | 79 | 76 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 |
| 27 | 253 | -1 | -1 | -1 | -1 | -1 | 145 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 |
| 28 | -1 | 240 | 12 | -1 | -1 | 50 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 |
| 29 | 31 | -1 | -1 | -1 | 63 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 |
| 30 | -1 | -1 | 141 | -1 | -1 | 96 | -1 | 222 | -1 | 33 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 |
| 31 | -1 | 90 | -1 | -1 | -1 | -1 | -1 | -1 | -1 | -1 | -1 | -1 | -1 | 9 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 |
| 32 | 185 | -1 | -1 | -1 | -1 | 68 | -1 | -1 | -1 | -1 | -1 | -1 | 40 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 |
| 33 | -1 | -1 | 209 | -1 | -1 | -1 | -1 | 152 | -1 | -1 | 35 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 |
| 34 | 233 | -1 | -1 | -1 | -1 | -1 | -1 | -1 | -1 | -1 | -1 | -1 | 174 | 138 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 |
| 35 | -1 | 177 | -1 | -1 | -1 | 232 | -1 | -1 | -1 | -1 | -1 | 89 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 |
| 36 | 193 | -1 | 12 | -1 | -1 | -1 | -1 | 248 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 |
| 37 | -1 | -1 | -1 | -1 | -1 | -1 | -1 | -1 | -1 | -1 | 8 | -1 | -1 | 252 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 |
| 38 | -1 | 165 | -1 | -1 | -1 | 206 | -1 | -1 | -1 | -1 | -1 | 200 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 |
| 39 | 138 | -1 | -1 | -1 | -1 | -1 | -1 | 250 | -1 | -1 | -1 | -1 | 13 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 |
| 40 | -1 | -1 | 226 | -1 | -1 | -1 | -1 | -1 | -1 | -1 | 35 | -1 | -1 | 148 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 |
| 41 | -1 | 227 | -1 | -1 | -1 | 30 | -1 | -1 | -1 | -1 | -1 | 151 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 |

Fig.8

| | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | 30 | 31 | 32 | 33 | 34 | 35 | 36 | 37 | 38 | 39 | 40 | 41 | 42 | 43 | 44 | 45 | 46 | 47 | 48 | 49 | 50 | 51 |
|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|
| 0 | 174 | 97 | 166 | 66 | -1 | -1 | 71 | -1 | -1 | 172 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 1 | 27 | -1 | -1 | 36 | 48 | 92 | 31 | 187 | 185 | 3 | -1 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 2 | 25 | 114 | -1 | 117 | 110 | -1 | -1 | -1 | 114 | -1 | 1 | -1 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 3 | -1 | 136 | 175 | -1 | 113 | 72 | 123 | 118 | 28 | 186 | 0 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 4 | 72 | 74 | -1 | -1 | -1 | -1 | -1 | -1 | -1 | -1 | -1 | 29 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 5 | 10 | 44 | -1 | -1 | -1 | 121 | -1 | 80 | -1 | -1 | -1 | 48 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 6 | 129 | -1 | -1 | -1 | -1 | 92 | -1 | 100 | -1 | 49 | -1 | 184 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 7 | -1 | 80 | -1 | -1 | -1 | 186 | -1 | 16 | -1 | -1 | -1 | 102 | -1 | 143 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 8 | 118 | 70 | -1 | -1 | -1 | -1 | -1 | -1 | -1 | -1 | -1 | -1 | 152 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 9 | -1 | 28 | -1 | -1 | -1 | -1 | -1 | -1 | 132 | -1 | 185 | 178 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 10 | 59 | 104 | -1 | -1 | -1 | -1 | 22 | 52 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 11 | 32 | -1 | -1 | -1 | -1 | -1 | -1 | 92 | -1 | 174 | -1 | -1 | -1 | 154 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 12 | -1 | 39 | -1 | 93 | -1 | -1 | -1 | -1 | -1 | -1 | -1 | 11 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 13 | 49 | 125 | -1 | -1 | -1 | -1 | -1 | -1 | 35 | -1 | -1 | -1 | -1 | 166 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 14 | -1 | 19 | -1 | -1 | -1 | -1 | 118 | -1 | -1 | -1 | -1 | 21 | -1 | 163 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 15 | 68 | -1 | -1 | -1 | -1 | -1 | -1 | -1 | -1 | -1 | 63 | 81 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 16 | -1 | 87 | -1 | -1 | -1 | -1 | -1 | -1 | -1 | 177 | -1 | 135 | 64 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 17 | -1 | 158 | -1 | -1 | -1 | 23 | -1 | -1 | -1 | -1 | -1 | 9 | 6 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 18 | 186 | -1 | -1 | -1 | -1 | -1 | 6 | 46 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 19 | 58 | 42 | -1 | -1 | -1 | -1 | -1 | -1 | -1 | -1 | 156 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 20 | -1 | 76 | -1 | -1 | 61 | -1 | -1 | -1 | -1 | -1 | -1 | 153 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 |
| 21 | 157 | -1 | -1 | -1 | -1 | -1 | -1 | -1 | 175 | -1 | -1 | -1 | -1 | 67 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 |
| 22 | -1 | 20 | 52 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 |
| 23 | 106 | -1 | -1 | 86 | -1 | 95 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 |
| 24 | -1 | 182 | 153 | -1 | -1 | -1 | -1 | -1 | -1 | 64 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 |
| 25 | 45 | -1 | -1 | -1 | -1 | 21 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 |
| 26 | -1 | -1 | 67 | -1 | -1 | -1 | -1 | 137 | -1 | -1 | -1 | -1 | 55 | 85 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 |
| 27 | 103 | -1 | -1 | -1 | -1 | -1 | 50 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 |
| 28 | -1 | 70 | 111 | -1 | -1 | 168 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 |
| 29 | 110 | -1 | -1 | -1 | 17 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 |
| 30 | -1 | -1 | 120 | -1 | -1 | 154 | -1 | 52 | -1 | 56 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 |
| 31 | -1 | 3 | -1 | -1 | -1 | -1 | -1 | -1 | -1 | -1 | -1 | -1 | -1 | 170 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 |
| 32 | 84 | -1 | -1 | -1 | -1 | 8 | -1 | -1 | -1 | -1 | -1 | -1 | 17 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 |
| 33 | -1 | -1 | 165 | -1 | -1 | -1 | -1 | 179 | -1 | -1 | 124 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 |
| 34 | 173 | -1 | -1 | -1 | -1 | -1 | -1 | -1 | -1 | -1 | -1 | -1 | 177 | 12 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 |
| 35 | -1 | 77 | -1 | -1 | -1 | 184 | -1 | -1 | -1 | -1 | -1 | 18 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 |
| 36 | 25 | -1 | 151 | -1 | -1 | -1 | -1 | 170 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 |
| 37 | -1 | -1 | -1 | -1 | -1 | -1 | -1 | -1 | -1 | -1 | 37 | -1 | -1 | 31 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 |
| 38 | -1 | 84 | -1 | -1 | -1 | 151 | -1 | -1 | -1 | -1 | -1 | 190 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 |
| 39 | 93 | -1 | -1 | -1 | -1 | -1 | -1 | 132 | -1 | -1 | -1 | -1 | 57 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 |
| 40 | -1 | -1 | 103 | -1 | -1 | -1 | -1 | -1 | -1 | -1 | 107 | -1 | -1 | 163 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 |
| 41 | -1 | 147 | -1 | -1 | -1 | 7 | -1 | -1 | -1 | -1 | -1 | 60 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 |

Fig.9

| | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | 30 | 31 | 32 | 33 | 34 | 35 | 36 | 37 | 38 | 39 | 40 | 41 | 42 | 43 | 44 | 45 | 46 | 47 | 48 | 49 | 50 | 51 |
|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|
| 0 | 154 | 145 | 81 | 110 | -1 | -1 | 19 | -1 | -1 | 72 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 1 | 42 | -1 | -1 | 85 | 81 | 125 | 39 | 112 | 124 | 16 | -1 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 2 | 119 | 52 | -1 | 23 | 145 | -1 | -1 | -1 | 116 | -1 | 1 | -1 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 3 | -1 | 78 | 109 | -1 | 103 | 66 | 68 | 87 | 5 | 154 | 0 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 4 | 112 | 134 | -1 | -1 | -1 | -1 | -1 | -1 | -1 | -1 | -1 | 92 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 5 | 134 | 82 | -1 | -1 | -1 | 29 | -1 | 21 | -1 | -1 | -1 | 158 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 6 | 27 | -1 | -1 | -1 | -1 | 61 | -1 | 55 | -1 | 124 | -1 | 142 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 7 | -1 | 101 | -1 | -1 | -1 | 71 | -1 | 151 | -1 | -1 | -1 | 95 | -1 | 30 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 8 | 32 | 21 | -1 | -1 | -1 | -1 | -1 | -1 | -1 | -1 | -1 | -1 | 104 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 9 | -1 | 55 | -1 | -1 | -1 | -1 | -1 | -1 | 80 | -1 | 1 | 35 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 10 | 32 | 129 | -1 | -1 | -1 | -1 | 120 | 51 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 11 | 18 | -1 | -1 | -1 | -1 | -1 | -1 | 64 | -1 | 102 | -1 | -1 | -1 | 62 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 12 | -1 | 127 | -1 | 131 | -1 | -1 | -1 | -1 | -1 | -1 | -1 | 48 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 13 | 36 | 51 | -1 | -1 | -1 | -1 | -1 | -1 | 28 | -1 | -1 | -1 | -1 | 88 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 14 | -1 | 11 | -1 | -1 | -1 | -1 | 123 | -1 | -1 | -1 | -1 | 88 | -1 | 85 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 15 | 32 | -1 | -1 | -1 | -1 | -1 | -1 | -1 | -1 | -1 | 1 | 54 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 16 | -1 | 31 | -1 | -1 | -1 | -1 | -1 | -1 | -1 | 152 | -1 | 4 | 153 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 17 | -1 | 96 | -1 | -1 | -1 | 15 | -1 | -1 | -1 | -1 | -1 | 88 | 141 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 18 | 58 | -1 | -1 | -1 | -1 | -1 | 2 | 158 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 19 | 22 | 156 | -1 | -1 | -1 | -1 | -1 | -1 | -1 | -1 | 7 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 20 | -1 | 20 | -1 | -1 | 61 | -1 | -1 | -1 | -1 | -1 | -1 | 39 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 |
| 21 | 38 | -1 | -1 | -1 | -1 | -1 | -1 | -1 | 1 | -1 | -1 | -1 | -1 | 78 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 |
| 22 | -1 | 45 | 29 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 |
| 23 | 134 | -1 | -1 | 75 | -1 | 102 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 |
| 24 | -1 | 72 | 61 | -1 | -1 | -1 | -1 | -1 | -1 | 88 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 |
| 25 | 16 | -1 | -1 | -1 | -1 | 55 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 |
| 26 | -1 | -1 | 31 | -1 | -1 | -1 | -1 | 155 | -1 | -1 | -1 | -1 | 91 | 78 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 |
| 27 | 117 | -1 | -1 | -1 | -1 | -1 | 23 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 |
| 28 | -1 | 49 | 142 | -1 | -1 | 142 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 |
| 29 | 152 | -1 | -1 | -1 | 43 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 |
| 30 | -1 | -1 | 11 | -1 | -1 | 42 | -1 | 52 | -1 | 34 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 |
| 31 | -1 | 159 | -1 | -1 | -1 | -1 | -1 | -1 | -1 | -1 | -1 | -1 | -1 | 5 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 |
| 32 | 68 | -1 | -1 | -1 | -1 | 108 | -1 | -1 | -1 | -1 | -1 | -1 | 35 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 |
| 33 | -1 | -1 | 133 | -1 | -1 | -1 | -1 | 148 | -1 | -1 | 137 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 |
| 34 | 63 | -1 | -1 | -1 | -1 | -1 | -1 | -1 | -1 | -1 | -1 | -1 | 92 | 90 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 |
| 35 | -1 | 80 | -1 | -1 | -1 | 34 | -1 | -1 | -1 | -1 | -1 | 70 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 |
| 36 | 98 | -1 | 147 | -1 | -1 | -1 | -1 | 150 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 |
| 37 | -1 | -1 | -1 | -1 | -1 | -1 | -1 | -1 | -1 | -1 | 58 | -1 | -1 | 122 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 |
| 38 | -1 | 38 | -1 | -1 | -1 | 20 | -1 | -1 | -1 | -1 | -1 | 122 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 |
| 39 | 86 | -1 | -1 | -1 | -1 | -1 | -1 | 80 | -1 | -1 | -1 | -1 | 109 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 |
| 40 | -1 | -1 | 94 | -1 | -1 | -1 | -1 | -1 | -1 | -1 | 137 | -1 | -1 | 143 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 |
| 41 | -1 | 55 | -1 | -1 | -1 | 91 | -1 | -1 | -1 | -1 | -1 | 121 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 |

Fig.10

| | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | 30 | 31 | 32 | 33 | 34 | 35 | 36 | 37 | 38 | 39 | 40 | 41 | 42 | 43 | 44 | 45 | 46 | 47 | 48 | 49 | 50 | 51 |
|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|
| 0 | 104 | 125 | 141 | 90 | -1 | -1 | 209 | -1 | -1 | 166 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 1 | 155 | -1 | -1 | 164 | 4 | 98 | 90 | 212 | 2 | 88 | -1 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 2 | 55 | 82 | -1 | 74 | 146 | -1 | -1 | -1 | 212 | -1 | 1 | -1 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 3 | -1 | 101 | 10 | -1 | 80 | 115 | 30 | 11 | 62 | 9 | 0 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 4 | 4 | 82 | -1 | -1 | -1 | -1 | -1 | -1 | -1 | -1 | -1 | 184 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 5 | 173 | 35 | -1 | -1 | -1 | 213 | -1 | 172 | -1 | -1 | -1 | 89 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 6 | 104 | -1 | -1 | -1 | -1 | 195 | -1 | 99 | -1 | 62 | -1 | 30 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 7 | -1 | 41 | -1 | -1 | -1 | 7 | -1 | 200 | -1 | -1 | -1 | 6 | -1 | 194 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 8 | 180 | 64 | -1 | -1 | -1 | -1 | -1 | -1 | -1 | -1 | -1 | -1 | 14 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 9 | -1 | 133 | -1 | -1 | -1 | -1 | -1 | -1 | 141 | -1 | 65 | 6 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 10 | 56 | 173 | -1 | -1 | -1 | -1 | 168 | 20 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 11 | 206 | -1 | -1 | -1 | -1 | -1 | -1 | 71 | -1 | 90 | -1 | -1 | -1 | 184 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 12 | -1 | 151 | -1 | 159 | -1 | -1 | -1 | -1 | -1 | -1 | -1 | 63 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 13 | 31 | 119 | -1 | -1 | -1 | -1 | -1 | -1 | 209 | -1 | -1 | -1 | -1 | 199 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 14 | -1 | 211 | -1 | -1 | -1 | -1 | 218 | -1 | -1 | -1 | -1 | 66 | -1 | 34 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 15 | 17 | -1 | -1 | -1 | -1 | -1 | -1 | -1 | -1 | -1 | 134 | 21 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 16 | -1 | 130 | -1 | -1 | -1 | -1 | -1 | -1 | -1 | 20 | -1 | 88 | 50 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 17 | -1 | 204 | -1 | -1 | -1 | 73 | -1 | -1 | -1 | -1 | -1 | 39 | 30 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 18 | 9 | -1 | -1 | -1 | -1 | -1 | 107 | 6 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 19 | 142 | 61 | -1 | -1 | -1 | -1 | -1 | -1 | -1 | -1 | 110 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 20 | -1 | 75 | -1 | -1 | 114 | -1 | -1 | -1 | -1 | -1 | -1 | 21 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 |
| 21 | 146 | -1 | -1 | -1 | -1 | -1 | -1 | -1 | 15 | -1 | -1 | -1 | -1 | 53 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 |
| 22 | -1 | 86 | 22 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 |
| 23 | 212 | -1 | -1 | 103 | -1 | 67 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 |
| 24 | -1 | 173 | 94 | -1 | -1 | -1 | -1 | -1 | -1 | 94 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 |
| 25 | 34 | -1 | -1 | -1 | -1 | 112 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 |
| 26 | -1 | -1 | 65 | -1 | -1 | -1 | -1 | 158 | -1 | -1 | -1 | -1 | 182 | 198 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 |
| 27 | 138 | -1 | -1 | -1 | -1 | -1 | 118 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 |
| 28 | -1 | 98 | 221 | -1 | -1 | 96 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 |
| 29 | 7 | -1 | -1 | -1 | 198 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 |
| 30 | -1 | -1 | 58 | -1 | -1 | 118 | -1 | 86 | -1 | 28 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 |
| 31 | -1 | 202 | -1 | -1 | -1 | -1 | -1 | -1 | -1 | -1 | -1 | -1 | -1 | 174 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 |
| 32 | 34 | -1 | -1 | -1 | -1 | 38 | -1 | -1 | -1 | -1 | -1 | -1 | 48 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 |
| 33 | -1 | -1 | 114 | -1 | -1 | -1 | -1 | 147 | -1 | -1 | 33 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 |
| 34 | 168 | -1 | -1 | -1 | -1 | -1 | -1 | -1 | -1 | -1 | -1 | -1 | 178 | 137 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 |
| 35 | -1 | 110 | -1 | -1 | -1 | 219 | -1 | -1 | -1 | -1 | -1 | 188 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 |
| 36 | 24 | -1 | 125 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 |
| 37 | -1 | -1 | -1 | -1 | -1 | -1 | -1 | -1 | -1 | -1 | 114 | -1 | -1 | 35 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 |
| 38 | -1 | 202 | -1 | -1 | -1 | 96 | -1 | -1 | -1 | -1 | -1 | 31 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 |
| 39 | 182 | -1 | -1 | -1 | -1 | -1 | -1 | 222 | -1 | -1 | -1 | -1 | 75 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 |
| 40 | -1 | -1 | 154 | -1 | -1 | -1 | -1 | -1 | -1 | -1 | 134 | -1 | -1 | 178 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 |
| 41 | -1 | 63 | -1 | -1 | -1 | 112 | -1 | -1 | -1 | -1 | -1 | 62 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 |

Fig.11

| |0|1|2|3|4|5|6|7|8|9|10|11|12|13|14|15|16|17|18|19|20|21|22|23|24|25|26|27|28|29|30|31|32|33|34|35|36|37|38|39|40|41|42|43|44|45|46|47|48|49|50|51|
|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|
|0|121|15|16|75|1|1|141|1|1|87|0|0|1|1|1|1|1|1|1|1|1|1|1|1|1|1|1|1|1|1|1|1|1|1|1|1|1|1|1|1|1|1|1|1|1|1|1|1|1|1|1|1|
|1|137|-1|-1|134|126|30|110|78|135|10|-1|0|0|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|
|2|69|95|-1|132|132|-1|-1|-1|33|-1|1|-1|0|0|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|
|3|-1|109|84|-1|44|112|99|29|50|39|0|-1|-1|0|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|
|4|16|13|-1|-1|-1|-1|-1|-1|-1|-1|-1|51|-1|-1|0|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|
|5|14|129|-1|-1|-1|48|-1|117|-1|-1|-1|71|-1|-1|-1|0|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|
|6|11|-1|-1|-1|-1|51|-1|15|-1|21|-1|67|-1|-1|-1|-1|0|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|
|7|-1|86|-1|-1|-1|135|-1|51|-1|-1|-1|0|-1|101|-1|-1|-1|0|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|
|8|44|58|-1|-1|-1|-1|-1|-1|-1|-1|-1|-1|88|-1|-1|-1|-1|-1|0|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|
|9|-1|86|-1|-1|-1|-1|-1|-1|34|-1|96|49|-1|-1|-1|-1|-1|-1|-1|0|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|
|10|128|30|-1|-1|-1|-1|19|76|-1|-1|-1|-1|-1|-1|-1|-1|-1|-1|-1|-1|0|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|
|11|2|-1|-1|-1|-1|-1|-1|46|-1|125|-1|-1|-1|64|-1|-1|-1|-1|-1|-1|-1|0|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|
|12|-1|22|-1|54|-1|-1|-1|-1|-1|-1|-1|23|-1|-1|-1|-1|-1|-1|-1|-1|-1|-1|0|-1|-1|-1|-1|-1|-1|-1|-1|-1|-1|-1|-1|-1|-1|-1|-1|-1|-1|-1|-1|-1|-1|-1|-1|-1|-1|-1|-1|-1|
|13|50|98|-1|-1|-1|-1|-1|-1|128|-1|-1|-1|-1|11|-1|-1|-1|-1|-1|-1|-1|-1|-1|0|-1|-1|-1|-1|-1|-1|-1|-1|-1|-1|-1|-1|-1|-1|-1|-1|-1|-1|-1|-1|-1|-1|-1|-1|-1|-1|-1|-1|
|14|-1|24|-1|-1|-1|-1|77|-1|-1|-1|-1|22|-1|97|-1|-1|-1|-1|-1|-1|-1|-1|-1|-1|0|-1|-1|-1|-1|-1|-1|-1|-1|-1|-1|-1|-1|-1|-1|-1|-1|-1|-1|-1|-1|-1|-1|-1|-1|-1|-1|-1|
|15|77|-1|-1|-1|-1|-1|-1|-1|-1|-1|60|20|-1|-1|-1|-1|-1|-1|-1|-1|-1|-1|-1|-1|-1|0|-1|-1|-1|-1|-1|-1|-1|-1|-1|-1|-1|-1|-1|-1|-1|-1|-1|-1|-1|-1|-1|-1|-1|-1|-1|-1|
|16|-1|73|-1|-1|-1|-1|-1|-1|-1|91|-1|28|8|-1|-1|-1|-1|-1|-1|-1|-1|-1|-1|-1|-1|-1|0|-1|-1|-1|-1|-1|-1|-1|-1|-1|-1|-1|-1|-1|-1|-1|-1|-1|-1|-1|-1|-1|-1|-1|-1|-1|
|17|-1|109|-1|-1|-1|43|-1|-1|-1|-1|-1|137|114|-1|-1|-1|-1|-1|-1|-1|-1|-1|-1|-1|-1|-1|-1|0|-1|-1|-1|-1|-1|-1|-1|-1|-1|-1|-1|-1|-1|-1|-1|-1|-1|-1|-1|-1|-1|-1|-1|-1|
|18|135|-1|-1|-1|-1|-1|132|122|-1|-1|-1|-1|-1|-1|-1|-1|-1|-1|-1|-1|-1|-1|-1|-1|-1|-1|-1|-1|0|-1|-1|-1|-1|-1|-1|-1|-1|-1|-1|-1|-1|-1|-1|-1|-1|-1|-1|-1|-1|-1|-1|-1|
|19|17|125|-1|-1|-1|-1|-1|-1|-1|-1|77|-1|-1|-1|-1|-1|-1|-1|-1|-1|-1|-1|-1|-1|-1|-1|-1|-1|-1|0|-1|-1|-1|-1|-1|-1|-1|-1|-1|-1|-1|-1|-1|-1|-1|-1|-1|-1|-1|-1|-1|-1|
|20|-1|63|-1|-1|125|-1|-1|-1|-1|-1|-1|114|-1|-1|-1|-1|-1|-1|-1|-1|-1|-1|-1|-1|-1|-1|-1|-1|-1|-1|0|-1|-1|-1|-1|-1|-1|-1|-1|-1|-1|-1|-1|-1|-1|-1|-1|-1|-1|-1|-1|-1|
|21|101|-1|-1|-1|-1|-1|-1|-1|113|-1|-1|-1|-1|117|-1|-1|-1|-1|-1|-1|-1|-1|-1|-1|-1|-1|-1|-1|-1|-1|-1|0|-1|-1|-1|-1|-1|-1|-1|-1|-1|-1|-1|-1|-1|-1|-1|-1|-1|-1|-1|-1|
|22|-1|7|131|-1|-1|-1|-1|-1|-1|-1|-1|-1|-1|-1|-1|-1|-1|-1|-1|-1|-1|-1|-1|-1|-1|-1|-1|-1|-1|-1|-1|-1|0|-1|-1|-1|-1|-1|-1|-1|-1|-1|-1|-1|-1|-1|-1|-1|-1|-1|-1|-1|
|23|42|-1|-1|83|-1|20|-1|-1|-1|-1|-1|-1|-1|-1|-1|-1|-1|-1|-1|-1|-1|-1|-1|-1|-1|-1|-1|-1|-1|-1|-1|-1|-1|0|-1|-1|-1|-1|-1|-1|-1|-1|-1|-1|-1|-1|-1|-1|-1|-1|-1|-1|
|24|-1|91|5|-1|-1|-1|-1|-1|-1|105|-1|-1|-1|-1|-1|-1|-1|-1|-1|-1|-1|-1|-1|-1|-1|-1|-1|-1|-1|-1|-1|-1|-1|-1|0|-1|-1|-1|-1|-1|-1|-1|-1|-1|-1|-1|-1|-1|-1|-1|-1|-1|
|25|138|-1|-1|-1|-1|63|-1|-1|-1|-1|-1|-1|-1|-1|-1|-1|-1|-1|-1|-1|-1|-1|-1|-1|-1|-1|-1|-1|-1|-1|-1|-1|-1|-1|-1|0|-1|-1|-1|-1|-1|-1|-1|-1|-1|-1|-1|-1|-1|-1|-1|-1|
|26|-1|-1|141|-1|-1|-1|-1|44|-1|-1|-1|-1|100|25|-1|-1|-1|-1|-1|-1|-1|-1|-1|-1|-1|-1|-1|-1|-1|-1|-1|-1|-1|-1|-1|-1|0|-1|-1|-1|-1|-1|-1|-1|-1|-1|-1|-1|-1|-1|-1|-1|
|27|131|-1|-1|-1|-1|-1|36|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|0|-1|-1|-1|-1|-1|-1|-1|-1|-1|-1|-1|-1|-1|-1|
|28|-1|95|4|-1|-1|79|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|0|-1|-1|-1|-1|-1|-1|-1|-1|-1|-1|-1|-1|-1|
|29|35|-1|-1|-1|119|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|0|-1|-1|-1|-1|-1|-1|-1|-1|-1|-1|-1|-1|
|30|-1|-1|86|-1|-1|56|-1|12|-1|72|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|0|-1|-1|-1|-1|-1|-1|-1|-1|-1|-1|-1|
|31|-1|33|-1|-1|-1|-1|-1|-1|-1|-1|-1|-1|-1|31|-1|-1|-1|-1|-1|-1|-1|-1|-1|-1|-1|-1|-1|-1|-1|-1|-1|-1|-1|-1|-1|-1|-1|-1|-1|-1|-1|0|-1|-1|-1|-1|-1|-1|-1|-1|-1|-1|
|32|42|-1|-1|-1|-1|53|-1|-1|-1|-1|-1|-1|71|-1|-1|-1|-1|-1|-1|-1|-1|-1|-1|-1|-1|-1|-1|-1|-1|-1|-1|-1|-1|-1|-1|-1|-1|-1|-1|-1|-1|-1|0|-1|-1|-1|-1|-1|-1|-1|-1|-1|
|33|-1|-1|62|-1|-1|-1|-1|22|-1|-1|110|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|0|-1|-1|-1|-1|-1|-1|-1|-1|
|34|83|-1|-1|-1|-1|-1|-1|-1|-1|-1|-1|-1|25|114|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|0|-1|-1|-1|-1|-1|-1|-1|
|35|-1|13|-1|-1|-1|65|-1|-1|-1|-1|-1|57|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|0|-1|-1|-1|-1|-1|-1|
|36|95|-1|56|-1|-1|-1|-1|42|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|0|-1|-1|-1|-1|-1|
|37|-1|-1|-1|-1|-1|-1|-1|-1|-1|-1|97|-1|-1|56|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|0|-1|-1|-1|-1|
|38|-1|62|-1|-1|-1|106|-1|-1|-1|-1|-1|109|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|0|-1|-1|-1|
|39|21|-1|-1|-1|-1|-1|-1|48|-1|-1|-1|-1|142|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|0|-1|-1|
|40|-1|-1|113|-1|-1|-1|-1|-1|-1|-1|37|-1|-1|102|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|0|-1|
|41|-1|109|-1|-1|-1|47|-1|-1|-1|-1|-1|19|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|-1|0|

Fig.12

| | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | 30 | 31 | 32 | 33 | 34 | 35 | 36 | 37 | 38 | 39 | 40 | 41 | 42 | 43 | 44 | 45 | 46 | 47 | 48 | 49 | 50 | 51 |
|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|
| 0 | 55 | 15 | 34 | 62 | -1 | -1 | 14 | -1 | -1 | 77 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 1 | 3 | -1 | -1 | 46 | 39 | 121 | 160 | 171 | 81 | 139 | -1 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 2 | 85 | 101 | -1 | 171 | 52 | -1 | -1 | -1 | 70 | -1 | 1 | -1 | 0 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 3 | -1 | 153 | 36 | -1 | 36 | 20 | 47 | 130 | 36 | 173 | 0 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 4 | 68 | 79 | -1 | -1 | -1 | -1 | -1 | -1 | -1 | -1 | -1 | 85 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 5 | 139 | 137 | -1 | -1 | -1 | 174 | -1 | 116 | -1 | -1 | -1 | 153 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 6 | 102 | -1 | -1 | -1 | -1 | 136 | -1 | 151 | -1 | 69 | -1 | 45 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 7 | -1 | 27 | -1 | -1 | -1 | 137 | -1 | 69 | -1 | -1 | -1 | 19 | -1 | 75 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 8 | 10 | 149 | -1 | -1 | -1 | -1 | -1 | -1 | -1 | -1 | -1 | -1 | 36 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 9 | -1 | 53 | -1 | -1 | -1 | -1 | -1 | -1 | 174 | -1 | 108 | 2 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 10 | 116 | 95 | -1 | -1 | -1 | -1 | 92 | 46 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 11 | 52 | -1 | -1 | -1 | -1 | -1 | -1 | 173 | -1 | 149 | -1 | -1 | -1 | 92 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 12 | -1 | 63 | -1 | 27 | -1 | -1 | -1 | -1 | -1 | -1 | -1 | 153 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 13 | 17 | 135 | -1 | -1 | -1 | -1 | -1 | -1 | 142 | -1 | -1 | -1 | -1 | 107 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 14 | -1 | 89 | -1 | -1 | -1 | -1 | 87 | -1 | -1 | -1 | -1 | 44 | -1 | 19 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 15 | 86 | -1 | -1 | -1 | -1 | -1 | -1 | -1 | -1 | -1 | 65 | 154 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 16 | -1 | 11 | -1 | -1 | -1 | -1 | -1 | -1 | -1 | 53 | -1 | 108 | 126 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 17 | -1 | 103 | -1 | -1 | -1 | 0 | -1 | -1 | -1 | -1 | -1 | 169 | 82 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 18 | 105 | -1 | -1 | -1 | -1 | -1 | 140 | 39 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 19 | 171 | 9 | -1 | -1 | -1 | -1 | -1 | -1 | -1 | -1 | 111 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 20 | -1 | 95 | -1 | -1 | 172 | -1 | -1 | -1 | -1 | -1 | -1 | 107 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 |
| 21 | 130 | -1 | -1 | -1 | -1 | -1 | -1 | -1 | 33 | -1 | -1 | -1 | -1 | 29 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 |
| 22 | -1 | 150 | 91 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 |
| 23 | 3 | -1 | -1 | 146 | -1 | 75 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 |
| 24 | -1 | 99 | 94 | -1 | -1 | -1 | -1 | -1 | -1 | 7 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 |
| 25 | 103 | -1 | -1 | -1 | -1 | 124 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 |
| 26 | -1 | -1 | 70 | -1 | -1 | -1 | -1 | 73 | -1 | -1 | -1 | -1 | 90 | 19 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 |
| 27 | 131 | -1 | -1 | -1 | -1 | -1 | 18 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 |
| 28 | -1 | 50 | 48 | -1 | -1 | 91 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 |
| 29 | 73 | -1 | -1 | -1 | 2 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 |
| 30 | -1 | -1 | 97 | -1 | -1 | 72 | -1 | 174 | -1 | 93 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 |
| 31 | -1 | 100 | -1 | -1 | -1 | -1 | -1 | -1 | -1 | -1 | -1 | -1 | -1 | 42 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 |
| 32 | 15 | -1 | -1 | -1 | -1 | 96 | -1 | -1 | -1 | -1 | -1 | -1 | 114 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 |
| 33 | -1 | -1 | 59 | -1 | -1 | -1 | -1 | 55 | -1 | -1 | 165 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 |
| 34 | 49 | -1 | -1 | -1 | -1 | -1 | -1 | -1 | -1 | -1 | -1 | -1 | 23 | 5 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 |
| 35 | -1 | 159 | -1 | -1 | -1 | 29 | -1 | -1 | -1 | -1 | -1 | 24 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 | -1 |
| 36 | 34 | -1 | 75 | -1 | -1 | -1 | -1 | 151 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 | -1 |
| 37 | -1 | -1 | -1 | -1 | -1 | -1 | -1 | -1 | -1 | -1 | 154 | -1 | -1 | 4 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | -1 |
| 38 | -1 | 30 | -1 | -1 | -1 | 149 | -1 | -1 | -1 | -1 | -1 | 148 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 |
| 39 | 81 | -1 | -1 | -1 | -1 | -1 | -1 | 172 | -1 | -1 | -1 | -1 | 49 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 |
| 40 | -1 | -1 | 33 | -1 | -1 | -1 | -1 | -1 | -1 | -1 | 13 | -1 | -1 | 104 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 |
| 41 | -1 | 159 | -1 | -1 | -1 | 165 | -1 | -1 | -1 | -1 | -1 | 150 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 |

Fig.13

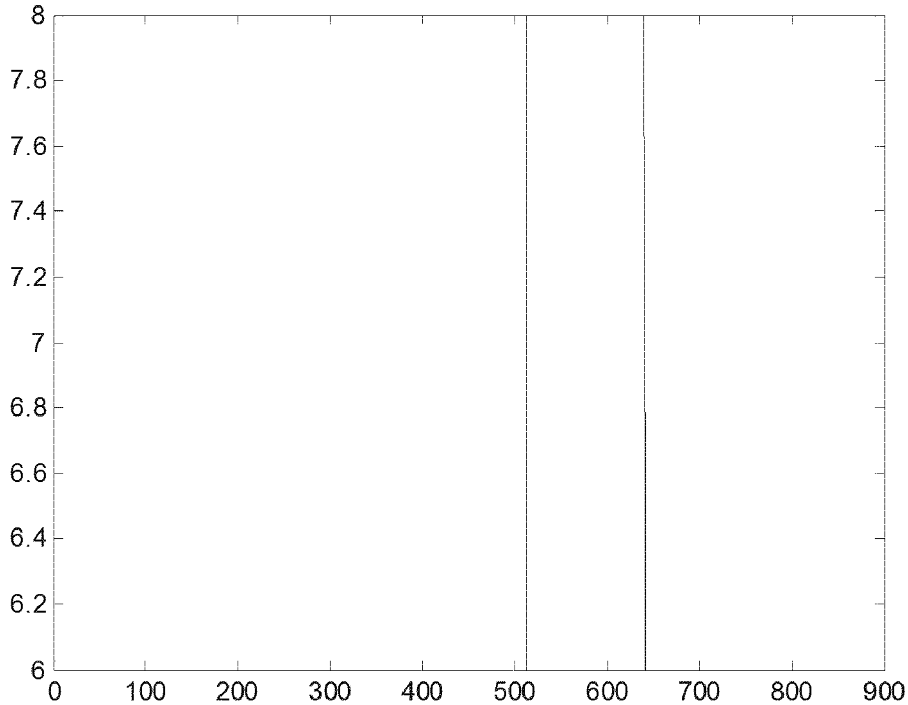


Fig. 14

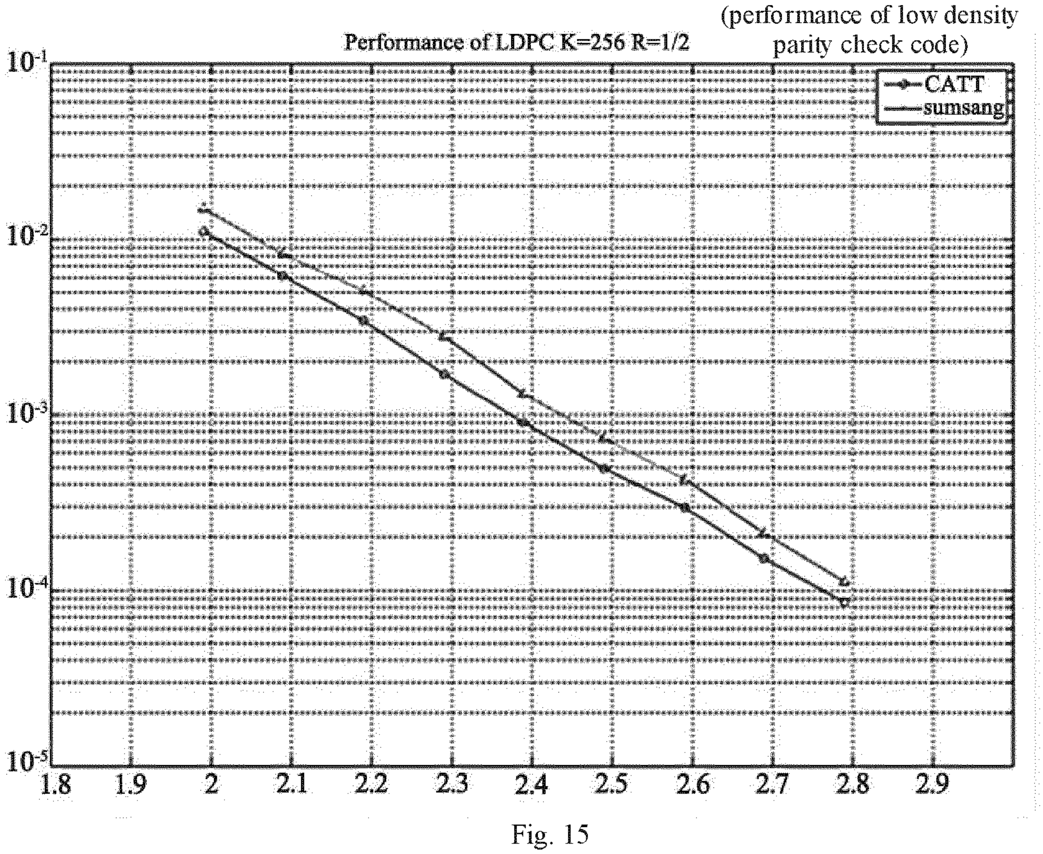
(performance of low density parity check code)
Performance of LDPC K=256 R=1/2
CATT
sumsang
10-1
10-2
10-3
10-4
10-5
1.8
1.9
2
2.1
2.2
2.3
2.4
2.5
2.6
2.7
2.8
2.9

Fig. 15

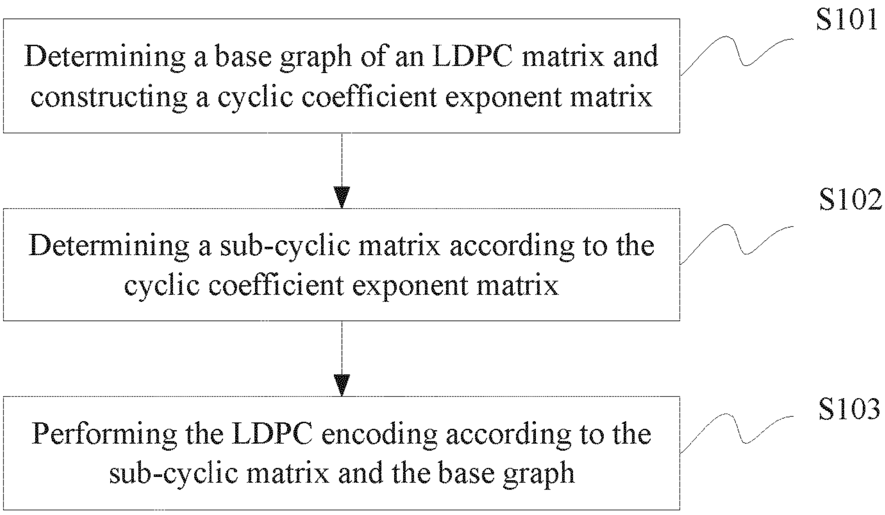
Determining a base graph of an LDPC matrix and constructing a cyclic coefficient exponent matrix
S101
Determining a sub-cyclic matrix according to the cyclic coefficient exponent matrix
S102
Performing the LDPC encoding according to the sub-cyclic matrix and the base graph
S103

Fig. 16

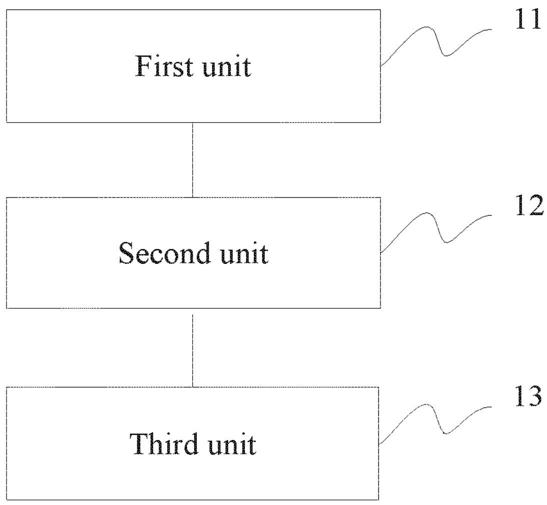
First unit
11
Second unit
12
Third unit
13

Fig. 17

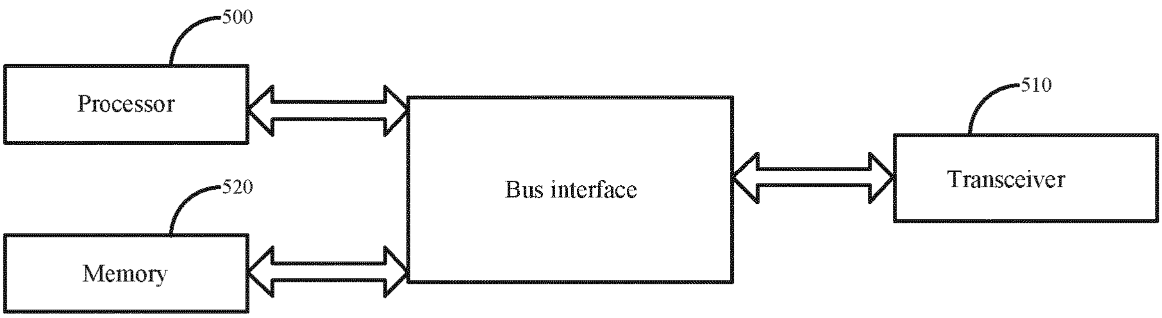
500
Processor
520
Memory
Bus interface
510
Transceiver

Fig. 18

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20100257425 A1
- US 20110289375 A1


### Non-patent literature cited in the description


- LDPC Code Design for NR. *R1-1608875*
- LDPC design for eMBB data. *R1-1710046*
- LDPC design for eMBB data channel. *R1-1704590*